# EUROPEAN PATENT APPLICATION

(11) **EP 4 852 667 A2**
(43) Date of publication of application: **09.12.2026**
(21) Application number: 26207377.8
(22) Date of filing: 05.01.2022
(51) Int. Cl.: H10F 77/00

(54) **PHOTOELECTRIC CONVERSION DEVICE AND PHOTODETECTION SYSTEM**

(30) Priority: 07.01.2021 JP 2021001441; 21.12.2021 JP 2021207158
(62) Document number(s) of the earlier application(s) in accordance with Art. 76 EPC: 22736744.8 / 4 277 263
(71) Applicant: Canon Kabushiki Kaisha, Ohta-ku Tokyo 146-8501 (JP)
(72) Inventor: OTA, Yasuharu, Tokyo, 146-8501 (JP); MORIMOTO, Kazuhiro, Tokyo, 146-8501 (JP)
(74) Representative: Canon Europe Limited

(57) **Abstract**

A photoelectric conversion apparatus comprises a pixel including an avalanche photodiode (201) including an anode and a cathode; a switch (202) connected between a power line to which a drive voltage (VH) is to be applied and either the anode or the cathode, and configured to receive pulse signals for controlling switching of the switch; and a signal processing circuit including a counter circuit connected to the avalanche photodiode, wherein a value obtained by dividing the number of the pulse signals in a first exposure period by the first exposure period, and a value obtained by dividing the number of the pulse signals in a second exposure period having a length different from a length of the first exposure period, by the second exposure period are different, wherein each of the first exposure period and the second exposure period is a period from a timing at which an exposure control signal input to the pixel changes to a first level to a timing at which the exposure control signal changes to a second level.

## Description

### Technical Field

The present invention relates to a photoelectric conversion apparatus that performs photoelectric conversion, an optical detection system, and a movable body.

### Background Art

There has been known a photoelectric conversion apparatus including a pixel array in which pixels including a plurality of avalanche photodiodes (APDs) are planarly arranged in a two-dimensional array. In a P-N junction region within a semiconductor region in each pixel, photo-charges inducted by a single photon cause avalanche multiplication.

Japanese Patent Application Laid-Open No. 2020-123847 discusses a pixel including an APD, a quench circuit connected to the APD, a signal control circuit to which a signal output from the APD is input, and a pulse generation circuit connected to the quench circuit and the signal control circuit. The pulse generation circuit controls on/off of the quench circuit. Japanese Patent Application Laid-Open No. 2020-123847 also discusses outputting a pulse signal corresponding to an input photon even under high luminance by resetting an output signal for each pulse signal.

Japanese Patent Application Laid-Open No. 2020-123847 does not discuss the number and the cycle of pulse signals within an exposure period that are to be output in a case where an exposure period varies. Japanese Patent Application Laid-Open No. 2020-123847 has the space to consider controlling pulse signals based on the relationship with an exposure period.

PTL 1: Japanese Patent Application Laid-Open No. 2020-123847

### Summary of Invention

A photoelectric conversion apparatus according to an aspect includes an avalanche photodiode including an anode and a cathode, a switch that is connected to one node of the anode and the cathode, and a power line to which a drive voltage is to be applied, and configured to switch a resistance value between the one node and the power line, and a signal generation unit configured to generate a pulse signal for controlling switching of the switch, wherein a value obtained by dividing the number of the pulse signals in a first exposure period by the first exposure period and multiplying the divided value by the first exposure period, and a value obtained by dividing the number of the pulse signals in a second exposure period having a length different from a length of the first exposure period, by the second exposure period and multiplying the divided value by the first exposure period are different.

### Brief Description of Drawings

[Fig. 1] Fig. 1 is a diagram illustrating a configuration of a photoelectric conversion apparatus.
[Fig. 2] Fig. 2 illustrates an arrangement example of a sensor substrate.
[Fig. 3] Fig. 3 illustrates an arrangement example of a circuit substrate.
[Fig. 4A] Fig. 4A is a block diagram including an equivalent circuit of a photoelectric conversion element.
[Fig. 4B] Fig. 4B is a block diagram including an equivalent circuit of a photoelectric conversion element.
[Fig. 5] Fig. 5 is a diagram illustrating a relationship between an operation of an avalanche photodiode (APD) and an output signal.
[Fig. 6A] Fig. 6A is a timing chart of a control pulse of a photoelectric conversion apparatus according to a first exemplary embodiment.
[Fig. 6B] Fig. 6B is a timing chart of a control pulse of the photoelectric conversion apparatus according to the first exemplary embodiment.
[Fig. 6C] Fig. 6C is a timing chart of a control pulse of the photoelectric conversion apparatus according to the first exemplary embodiment.
[Fig. 7A] Fig. 7A is a timing chart of a control pulse of a photoelectric conversion apparatus according to a comparative configuration.
[Fig. 7B] Fig. 7B is a timing chart of a control pulse of the photoelectric conversion apparatus according to the comparative configuration.
[Fig. 7C] Fig. 7C is a timing chart of a control pulse of the photoelectric conversion apparatus according to the comparative configuration.
[Fig. 8] Fig. 8 is a flowchart illustrating an example of an operation mode of the photoelectric conversion apparatus according to the first exemplary embodiment.
[Fig. 9A] Fig. 9A is a timing chart of a control pulse of a photoelectric conversion apparatus according to a modified example of the first exemplary embodiment.
[Fig. 9B] Fig. 9B is a timing chart of a control pulse of the photoelectric conversion apparatus according to the modified example of the first exemplary embodiment.
[Fig. 9C] Fig. 9C is a timing chart of a control pulse of the photoelectric conversion apparatus according to the modified example of the first exemplary embodiment.
[Fig. 9D] Fig. 9D is a timing chart of a control pulse of a photoelectric conversion apparatus according to a modified example of the first exemplary embodiment.
[Fig. 9E] Fig. 9E is a timing chart of a control pulse of the photoelectric conversion apparatus according to the modified example of the first exemplary embodiment.
[Fig. 9F] Fig. 9F is a timing chart of a control pulse of the photoelectric conversion apparatus according to the modified example of the first exemplary embodiment.
[Fig. 10A] Fig. 10A is a timing chart of a control pulse of a photoelectric conversion apparatus according to a second exemplary embodiment.
[Fig. 10B] Fig. 10B is a timing chart of a control pulse of the photoelectric conversion apparatus according to the second exemplary embodiment.
[Fig. 10C] Fig. 10C is a timing chart of a control pulse of the photoelectric conversion apparatus according to the second exemplary embodiment.
[Fig. 11] Fig. 11 is a diagram illustrating a relationship between the number of incident photons and a count value per exposure period of a photoelectric conversion apparatus according to a third exemplary embodiment.
[Fig. 12] Fig. 12 illustrates an arrangement example of a circuit substrate of the photoelectric conversion apparatus according to the third exemplary embodiment.
[Fig. 13A] Fig. 13A is a timing chart of a control pulse of the photoelectric conversion apparatus according to the third exemplary embodiment.
[Fig. 13B] Fig. 13B is a timing chart of a control pulse of the photoelectric conversion apparatus according to the third exemplary embodiment.
[Fig. 14] Fig. 14 is a block diagram of an optical detection system according to a fourth exemplary embodiment.
[Fig. 15] Fig. 15 is a block diagram of an optical detection system according to a fifth exemplary embodiment.
[Fig. 16] Fig. 16 is a block diagram of an optical detection system according to a sixth exemplary embodiment.
[Fig. 17A] Fig. 17A is a block diagram of an optical detection system according to a seventh exemplary embodiment.
[Fig. 17B] Fig. 17B is a block diagram of the optical detection system according to the seventh exemplary embodiment.
[Fig. 18] Fig. 18 is a flowchart of the optical detection system according to the seventh exemplary embodiment.
[Fig. 19A] Fig. 19A is a diagram illustrating a specific example of an electronic device according to an eighth exemplary embodiment.
[Fig. 19B] Fig. 19B is a diagram illustrating a specific example of an electronic device according to the eighth exemplary embodiment.

### Description of Embodiments

The following exemplary embodiments are provided to embody the technical idea of the present invention, and are not intended to limit the present invention. The sizes and the positional relationship of members illustrated in the drawings are sometimes exaggerated to clarify the description. In the following description, the same components are assigned the same reference numerals, and the description thereof will be sometimes omitted.

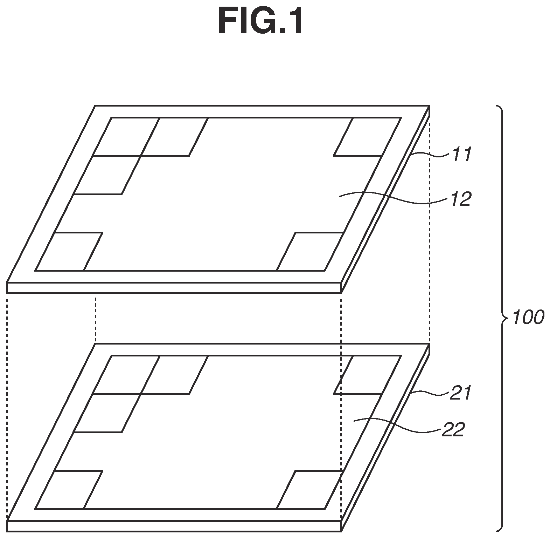

Configurations common to photoelectric conversion apparatuses according to exemplary embodiments will be described with reference to Figs. 1 to 4B. The photoelectric conversion apparatus includes a single photon avalanche diode (SPAD) pixel including an avalanche photodiode (APD). Among charge pairs generated in an avalanche diode, the conductivity type of charges to be used as signal charges will be referred to as a first conductivity type. The first conductivity type refers to a conductivity type in which charges of the same polarity as the polarity of signal charges are regarded as majority carriers. In addition, a conductivity type opposite to the first conductivity type will be referred to as a second conductivity type. The following description will be given of an example in which signal charges are electrons, the first conductivity type is an N-type, and the second conductivity type is a P-type, but signal charges may be holes, the first conductivity type may be the P-type, and the second conductivity type may be the N-type.

While signals are read out from a cathode of an APD in a case where signal charges are electrons, signals are read out from an anode of an APD in a case where signal charges are holes. Accordingly, the cathode and the anode of the APD have an opposite relationship.

In this specification, a "planar view" refers to a view from a direction vertical to a light incidence surface of a semiconductor layer in which a photoelectric conversion element to be described below is arranged. In addition, a cross section refers to a surface in the direction vertical to the light incidence surface of the semiconductor layer in which the photoelectric conversion element is arranged. In a case where the light incidence surface of the semiconductor layer is a rough surface when viewed microscopically, a planar view is defined based on a light incidence surface of a semiconductor layer that is viewed macroscopically.

First of all, a configuration common to the exemplary embodiments will be described.

Fig. 1 is a diagram illustrating a configuration of a photoelectric conversion apparatus 100 according to an exemplary embodiment of the present invention. The following description will be given using an example case where the photoelectric conversion apparatus 100 is a stack-type photoelectric conversion apparatus. In other words, the description will be given using, as an example, a photoelectric conversion apparatus including two stacked substrates corresponding to a sensor substrate 11 and a circuit substrate 21, which are electrically connected. Nevertheless, the photoelectric conversion apparatus is not limited to this. For example, the photoelectric conversion apparatus may be a photoelectric conversion apparatus in which components included in the sensor substrate 11 and components included in the circuit substrate, which will be described below, are arranged in a common semiconductor layer. In the following description, the photoelectric conversion apparatus in which components included in the sensor substrate 11 and components included in the circuit substrate are arranged in a common semiconductor layer will also be referred to as a non-stacked photoelectric conversion apparatus.

The sensor substrate 11 includes a first semiconductor layer including a photoelectric conversion element 102 to be described below, and a first wiring structure. The circuit substrate 21 includes a second semiconductor layer including a circuit such as a signal processing circuit 103 to be described below, and a second wiring structure. The photoelectric conversion apparatus 100 includes the second semiconductor layer, the second wiring structure, the first wiring structure, and the first semiconductor layer, which are stacked in this order.

Fig. 1 illustrates a back-illuminated photoelectric conversion apparatus that receives light entering from a first surface, and includes a circuit substrate arranged on a second surface being a surface opposite to the first surface. In a case where the photoelectric conversion apparatus 100 is a non-stacked photoelectric conversion apparatus, a surface on which a transistor of a signal processing circuit is arranged will be referred to as a second surface. In a case where the photoelectric conversion apparatus 100 is a back-illuminated photoelectric conversion apparatus, the first surface of a semiconductor layer that is on the opposite side of the second surface serves as a light incidence surface. In a case where the photoelectric conversion apparatus 100 is a front-illuminated photoelectric conversion apparatus, the second surface of a semiconductor layer serves as a light incidence surface.

In the following description, the sensor substrate 11 and the circuit substrate 21 will be described as singulated chips, but the sensor substrate 11 and the circuit substrate 21 are not limited to such chips. For example, each substrate may be a wafer. Alternatively, the substrates may be singulated after being stacked in a wafer state, or may be singulated into chips and then jointed by stacking the chips.

A pixel region 12 is arranged on the sensor substrate 11, and a circuit region 22 for processing signals detected in the pixel region 12 is arranged on the circuit substrate 21.

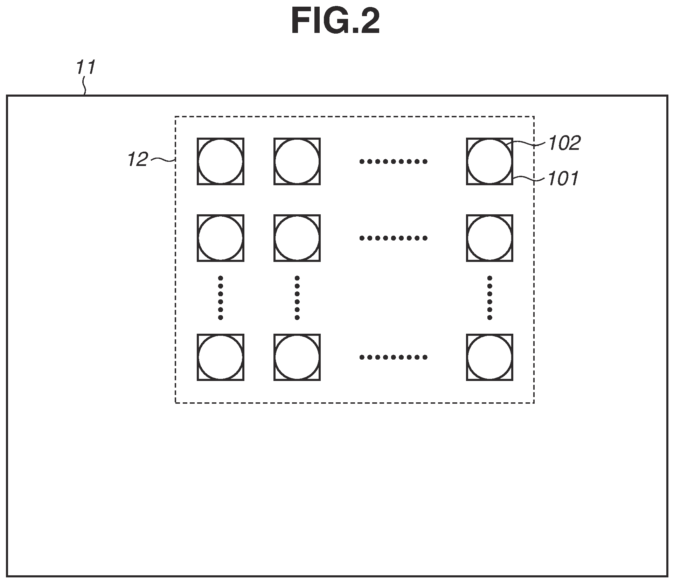

Fig. 2 is a diagram illustrating an arrangement example of the sensor substrate 11. Pixels 101 each including the photoelectric conversion element 102 including an avalanche photodiode (hereinafter, APD) are arranged in a two-dimensional array in a planar view, and form the pixel region 12.

Typically, the pixel 101 is a pixel for forming an image. In a case where the pixel 101 is used in a time of flight (TOF) sensor, an image need not be always formed. That is, the pixel 101 may be a pixel for measuring a time at which light reaches, and for measuring a light amount.

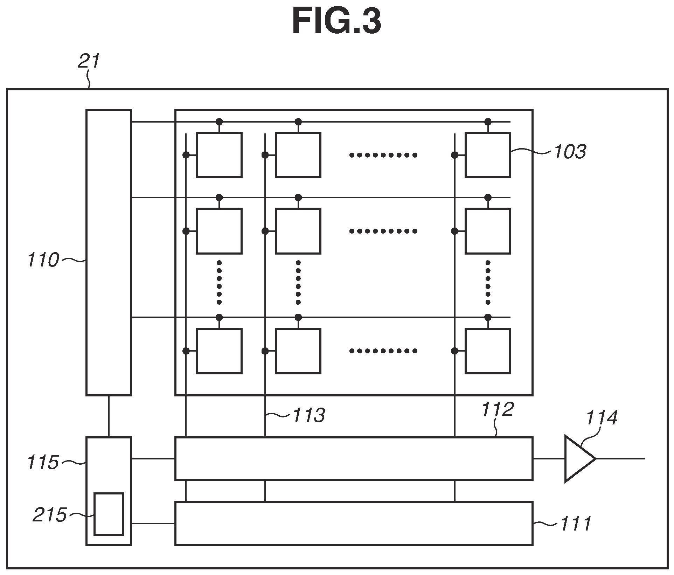

Fig. 3 is a configuration diagram of the circuit substrate 21. The circuit substrate 21 includes the signal processing circuit 103 that processes charges photoelectrically-converted by the photoelectric conversion element 102 illustrated in Fig. 2, a readout circuit 112, a control pulse generation unit 115, a horizontal scanning circuit unit 111, a signal line 113, and a vertical scanning circuit unit 110.

The photoelectric conversion element 102 illustrated in Fig. 2 and the signal processing circuit 103 illustrated in Fig. 3 are electrically connected via a connection wire provided for each pixel.

The vertical scanning circuit unit 110 receives a control pulse supplied from the control pulse generation unit 115, and supplies the control pulse to each pixel. A logic circuit such as a shift register or an address decoder is used as the vertical scanning circuit unit 110.

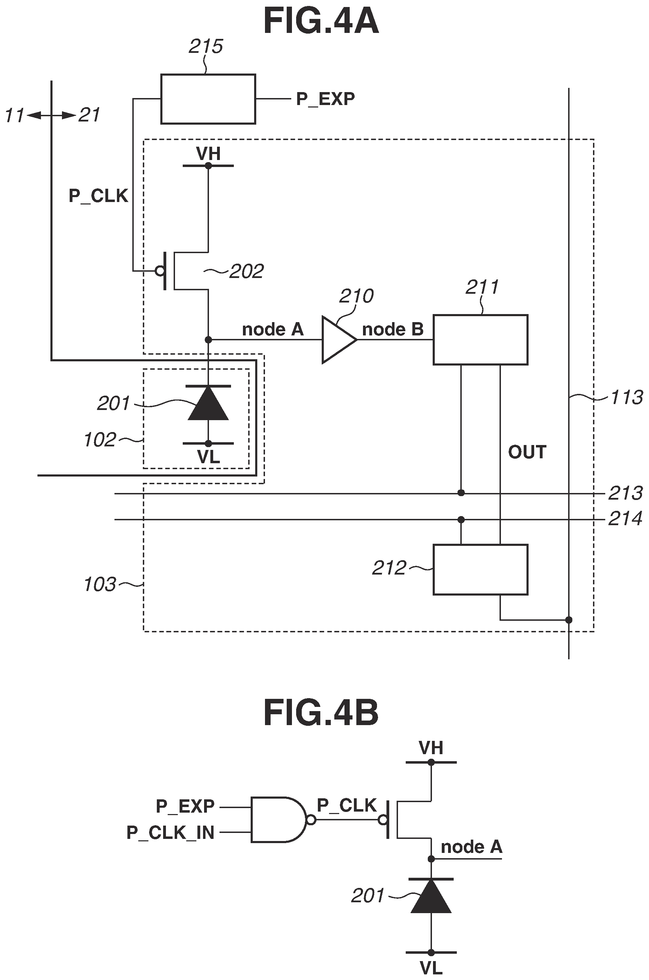

The control pulse generation unit 115 includes a signal generation unit 215 that generates a control signal P_CLK of a switch, which will be described below. As described below, the signal generation unit 215 generates a pulse signal for controlling the switch. As illustrated in Fig. 4A, for example, the signal generation unit 215 may generate a common control signal P_CLK for a plurality of pixels in a pixel region, or as illustrated in Fig. 4B, the signal generation unit 215 may generate the control signal P_CLK for each pixel. In a case where the signal generation unit 215 generates the common pulse signal P_CLK, the signal generation unit 215 generates the control signal P_CLK in common in such a manner that at least any one of a cycle of a pulse signal P_EXP for controlling an exposure period, the number of pulses, and the pulse width is associated with an exposure period. In a case where the signal generation unit 215 controls the control signal P_CLK for each pixel, the signal generation unit 215 can generate the control signal P_CLK using both of an input signal P_CLK_IN output from the control pulse generation unit 115, and the signal P_EXP for controlling an exposure period. The control pulse generation unit 115 desirably includes a frequency divider circuit, for example. This enables simple control and can reduce an increase in the number of elements.

A signal output from the photoelectric conversion element 102 of a pixel is processed by the signal processing circuit 103. A counter and a memory are provided in the signal processing circuit 103, and a digital value is stored in the memory.

The horizontal scanning circuit unit 111 inputs, to the signal processing circuit 103, a control pulse for sequentially selecting each column to read out a signal from the memory of each pixel that stores a digital signal.

A signal is output to the signal line 113 from the signal processing circuit 103 corresponding to a pixel selected by the vertical scanning circuit unit 110 on a selected column.

The signal output to the signal line 113 is output via an output circuit 114 to a recording unit or a signal processing unit that is provided on the outside of the photoelectric conversion apparatus 100.

In Fig. 2, photoelectric conversion elements in a pixel region may be one-dimensionally arrayed. Even in a case where the number of pixels is one, the effect of the present invention can be obtained, and a case where the number of pixels is one is also included in the present invention. Nevertheless, if a photoelectric conversion apparatus includes a plurality of pixels, a power consumption reduction effect of the present exemplary embodiment can be obtained more easily. The function of the signal processing unit need not be provided for each of all photoelectric conversion elements. For example, one signal processing unit may be shared by a plurality of photoelectric conversion elements, and signal processing may be sequentially performed.

As illustrated in Figs. 2 and 3, a plurality of signal processing circuits 103 is arranged in a region overlapping the pixel region 12 in a planar view. Then, the vertical scanning circuit unit 110, the horizontal scanning circuit unit 111, the readout circuit 112, the output circuit 114, and the control pulse generation unit 115 are arranged in such a manner as to overlap, in a planar view, a region defined by the ends of the sensor substrate 11 and the ends of the pixel region 12. In other words, the sensor substrate 11 includes the pixel region 12, and a non-pixel region arranged around the pixel region 12. Then, the vertical scanning circuit unit 110, the horizontal scanning circuit unit 111, the readout circuit 112, output circuit 114, and the control pulse generation unit 115 are arranged in a region overlapping the non-pixel region in a planar view.

The arrangement of the signal lines 113, and the arrangement of the readout circuit 112 and the output circuit 114 are not limited to those illustrated in Fig. 3. For example, the signal lines 113 may be arranged with extending in a row direction, and the readout circuit 112 may be arranged at the ends of the extending signal lines 113.

Figs. 4A and 4B each illustrate an example of a block diagram including an equivalent circuit of Figs. 2 and 3. Fig. 4A illustrates an example in which the signal generation unit 215 is provided in common to a plurality of pixels, and Fig. 4B illustrates an example in which the control signal P_CLK can be controlled for each pixel.

In Fig. 4A, the photoelectric conversion element 102 including an APD 201 is provided on the sensor substrate 11, and other members are provided on the circuit substrate 21.

The APD 201 generates a charge pair corresponding to incident light, by photoelectric conversion. One node of two nodes of the APD 201 is connected to a power line to which a drive voltage VL (first voltage) is supplied. The other node of the two nodes of the APD 201 is connected to a power line to which a drive voltage VH (second voltage) higher than the drive voltage VL supplied to the anode is supplied. In Figs. 4A and 4B, one node of the APD 201 is an anode, and the other node of the APD 201 is a cathode. Inversely-biased voltages for causing the APD 201 to perform an avalanche multiplication operation are supplied to the anode and the cathode of the APD 201. By causing a state in which such voltages are supplied, charges generated by incident light cause avalanche multiplication, and an avalanche current is generated.

In a case where inversely-biased voltages are supplied, an APD is operated in a Geiger mode or a linear mode. In the Geiger mode, an APD is operated with a potential difference between the anode and the cathode that is larger than a breakdown voltage. In the linear mode, an APD is operated with a potential difference between the anode and the cathode that is near a breakdown voltage, or with a voltage difference equal to or smaller than the breakdown voltage.

An APD operated in the Geiger mode will be referred to as an SPAD. For example, the drive voltage VL (first voltage) is -30 V and the drive voltage VH (second voltage) is 1 V. The APD 201 may be operated in the linear mode, or may be operated in the Geiger mode. Because a potential difference of the SPAD becomes larger and a voltage resistance effect of the SPAD becomes more prominent as compared with an APD in the linear mode, the SPAD is desirably used.

A switch 202 is connected to the power line to which the drive voltage VH is supplied, and one node of the anode and the cathode of the APD 201. Then, the switch 202 switches a resistance value between the APD 201 and the power line to which the drive voltage VH is supplied. Here, switching a resistance value preferably changes a resistance value to a tenfold resistance value or more, and more preferably changes a resistance value to a hundredfold resistance value or more. Hereinafter, decreasing the resistance value will also be referred to as turning the switch 202 on, and increasing the resistance value will also be referred to as turning the switch 202 off. The switch 202 functions as a quench element. The switch 202 functions as a load circuit (quench circuit) when a signal is multiplied by avalanche multiplication, and has a function of suppressing avalanche multiplication by suppressing a voltage to be supplied to the APD 201 (quench operation). The switch 202 also has a function of returning a voltage to be supplied to the APD 201, to the drive voltage VH by flowing a current by an amount corresponding to a voltage drop caused by the quench operation (recharge operation).

The switch 202 can include a metal-oxide semiconductor (MOS) transistor, for example. Figs. 4A and 4B illustrate a case where the switch 202 is a P-channel MOS (PMOS) transistor. The control signal P_CLK of the switch 202 that is supplied from the signal generation unit 215 is applied to a gate electrode of the MOS transistor included in the switch 202. In the present exemplary embodiment, by controlling an applied voltage to the gate electrode of the switch 202, on and off of the switch 202 are controlled.

The signal processing circuit 103 includes a waveform shaping unit 210, a counter circuit 211, and a selection circuit 212. In Fig. 4A, the signal processing circuit 103 includes the waveform shaping unit 210, the counter circuit 211, and the selection circuit 212, but in this specification, the signal processing circuit 103 is only required to include at least any one of the waveform shaping unit 210, the counter circuit 211, and the selection circuit 212.

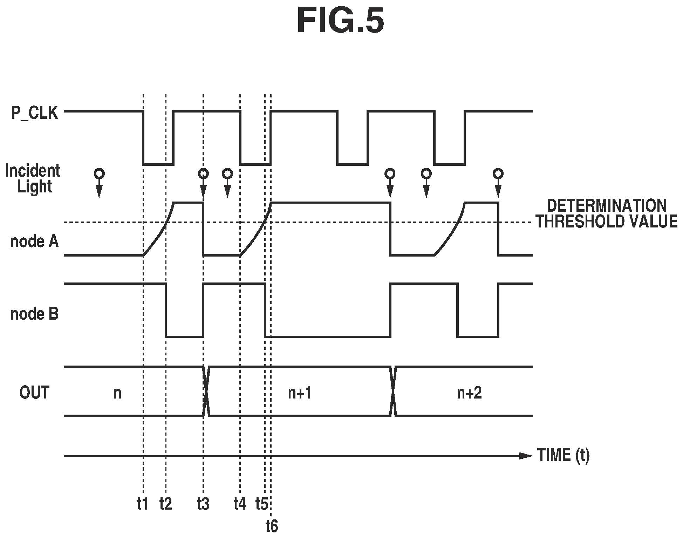

The waveform shaping unit 210 outputs a pulse signal by shaping a potential change of the cathode of the APD 201 that is obtained at the time of photon detection. An input side node of the waveform shaping unit 210 is regarded as a node A and an output side node is regarded as a node B. The waveform shaping unit 210 changes an output potential from the node B depending on whether an input potential to the node A is equal to or larger than a predetermined value or lower than the predetermined value. For example, in Fig. 5, if an input potential to the node A becomes a high potential equal to or larger than a determination threshold value, an output potential from the node B becomes a low level. Then, if an input potential to the node A becomes a potential lower than the determination threshold value, an output potential from the node B becomes a high level. For example, an inverter circuit is used as the waveform shaping unit 210. Fig. 4A illustrates an example in which one inverter is used as the waveform shaping unit 210, but a circuit in which a plurality of inverters is connected in series may be used, or another circuit having a waveform shaping effect may be used.

The quench operation and the recharge operation can be performed using the switch 202 in accordance with avalanche multiplication in the APD 201, but in some cases, a photon is not determined as an output signal depending on the detection timing of the photon. For example, when avalanche multiplication occurs in an APD, an input potential to the node A becomes a low level, and the recharge operation is being performed, the determination threshold value of the waveform shaping unit 210 is generally set to a potential higher than a potential difference at which avalanche multiplication occurs in an APD. If a photon enters when a potential at the node A is lower than the determination threshold value due to the recharge operation, and is a potential at which avalanche multiplication can occur in an APD, avalanche multiplication occurs in an APD, and a voltage at the node A drops. In other words, because the potential at the node A drops at a voltage lower than the determination threshold value, although a photon is detected, an output potential from the node B does not change. Accordingly, although avalanche multiplication occurs, a photon stops being determined as a signal. Especially under high illuminance, because photons consecutively enter in a short period, the photons become difficult to be determined as signals. For this reason, in spite of the high illuminance, a discrepancy easily arises between the number of actual incident photons and the number of output signals.

In contrast to this, by switching between on and off of the switch 202 by applying the control signal P_CLK to the switch 202, also in a case where photons consecutively enter an APD in a short time, the photons can be determined as signals. An example in which the control signal P_CLK is a pulse signal output at a repeat cycle will be described with reference to Fig. 5. In other words, a configuration in which on/off of the switch 202 is switched at a predetermined clock frequency will be described with reference to Fig. 5. Nevertheless, an effect of suppressing an increase in power consumption of a photoelectric conversion apparatus can be obtained even if a pulse signal is not a signal output at a repeat cycle.

The counter circuit 211 counts the number of pulse signals output from the waveform shaping unit 210, and stores a count value. When a control pulse pRES is supplied via a drive line 213, the number of pulse signals that is stored in the counter circuit 211 is reset.

A control pulse pSEL is supplied to the selection circuit 212 from the vertical scanning circuit unit 110 illustrated in Fig. 3, via a drive line 214 illustrated in Fig. 4A (not illustrated in Fig. 3), and electric connection and disconnection between the counter circuit 211 and the signal line 113 are switched. The selection circuit 212 includes a buffer circuit for outputting a signal, for example. An output signal OUT illustrated in Fig. 4A is a signal output from a pixel.

Electric connection may be switched by arranging a switch such as a transistor between the switch 202 and the APD 201, or between the photoelectric conversion element 102 and the signal processing circuit 103. Similarly, the supply of the drive voltage VH or the drive voltage VL to be supplied to the photoelectric conversion element 102 may be electrically switched using a switch such as a transistor.

In the present exemplary embodiment, the configuration that uses the counter circuit 211 has been described. Nevertheless, the photoelectric conversion apparatus 100 may acquire a pulse detection timing using a time to digital converter (hereinafter, TDC) and a memory in place of the counter circuit 211. At this time, the generation timing of a pulse signal output from the waveform shaping unit 210 is converted into a digital signal by the TDC. To measure the timing of a pulse signal, a control pulse pREF (reference signal) is supplied to the TDC via a drive line from the vertical scanning circuit unit 110 illustrated in Fig. 3. Based on the control pulse pREF, the TDC acquires a digital signal indicating an input timing of a signal output from each pixel via the waveform shaping unit 210, as a relative time.

As illustrated in Fig. 4B, the signal generation unit 215 may be provided for each pixel. In Fig. 4B, the illustration of the waveform shaping unit 210, a circuit following the waveform shaping unit 210, and the signal generation unit, which are illustrated in Fig. 4A, is omitted. The signal generation unit 215 in Fig. 4A is assumed to be provided for each pixel. In Fig. 4B, a logic circuit is provided in a pixel, and whether to supply a pulse signal to the switch 202 is determined. The signal P_EXP for controlling an exposure period, and an input signal P_CLK_IN for controlling the control signal P_CLK are input to the logic circuit. Then, a reversing signal is output. For example, in a case where the signal P_EXP for controlling an exposure period is at a low level and the input signal P_CLK_IN is at a low level, a high-level signal is output as the control signal P_CLK. In other words, the switch is turned off. In a case where the signal P_EXP for controlling an exposure period is at a high level and the input signal P_CLK_IN is at a high level, a low-level signal is output as the control signal P_CLK. In other words, the switch is turned on. In addition, in a case where one of the signal P_EXP for controlling an exposure period and the input signal P_CLK_IN is at the low level, a high-level signal is output as the control signal P_CLK. In other words, the switch 202 is turned off. In this manner, it is desirable to control the switch for each pixel. In a case where the circuit illustrated in Fig. 4B is used, as described below in a second exemplary embodiment, if an exposure period P becomes a low level, the control signal P_CLK is maintained at the high level. In other words, the switch is turned off.

Fig. 5 is a diagram schematically illustrating a relationship between the control signal P_CLK of the switch, a potential at the node A, a potential at the node B, and an output signal. In the present exemplary embodiment, in a case where the control signal P_CLK is at the high level, the drive voltage VH becomes less likely to be supplied to an APD, and in a case where the control signal P_CLK is at the low level, the drive voltage VH is supplied to an APD. The high level of the control signal P_CLK is 1 V, for example, and the low level of the control signal P_CLK is 0 V, for example. Inacase where the control signal P_CLK is at the high level, the switch is turned off, and in a case where the control signal P_CLK is at the low level, the switch is turned on. A resistance value of the switch that is set in a case where the control signal P_CLK is at the high level becomes higher than a resistance value of the switch that is set in a case where the control signal P_CLK is at the low level. In a case where the control signal P_CLK is at the high level, because the recharge operation is less likely to be performed even if avalanche multiplication occurs in an APD, a potential to be supplied to the APD becomes a potential equal to or smaller than a breakdown voltage of the APD. Accordingly, an avalanche multiplication operation in the APD stops.

As illustrated in Figs. 4A and 4B, it is desirable that the switch 202 includes one transistor, and the quench operation and the recharge operation are performed using the one transistor. With this configuration, as compared with a case where the quench operation and the recharge operation are performed using different circuit elements, the number of circuits can be reduced. Particularly in a case where each pixel includes a counter circuit, and a signal of an SPAD is read out for each pixel, to arrange the counter circuits, it is desirable to reduce a circuit area used for a switch, and an effect obtained by the switch 202 including one transistor becomes prominent.

At a time t1, the control signal P_CLK changes from a high level to a low level, the switch is turned on, and the recharge operation of the APD is started. A potential at the cathode of the APD thereby transitions to a high level. Then, a potential difference between potentials to be applied to the anode and the cathode of the APD becomes a state in which avalanche multiplication can occur. A potential at the cathode is the same as the potential at the node A. Accordingly, when the potential at the cathode transitions from a low level to a high level, at a time t2, the potential at the node A becomes equal to or larger than the determination threshold value. At this time, a pulse signal output from the node B is reversed from a high level to a low level. After that, a potential difference corresponding to (the drive voltage VH - the drive voltage VL) is applied to the APD 201. The control signal P_CLK becomes the high level, and the switch is turned off.

Next, if a photon enters the APD 201 at a time t3, avalanche multiplication occurs in the APD 201, an avalanche multiplication current flows to the switch 202, and a voltage at the cathode drops. In other words, a voltage at the node A drops. If a voltage drop amount further increases, and a potential difference applied to the APD 201 becomes smaller, avalanche multiplication of the APD 201 stops at the time t2, and a voltage level at the node A stops dropping from a certain fixed value. If the voltage at the node A becomes lower than the determination threshold value while the voltage at the node A is dropping, a voltage at the node B changes from a low level to a high level. In other words, a portion with an output waveform exceeding the determination threshold at the node A is subjected to waveform shaping performed by the waveform shaping unit 210, and output as a signal at the node B. Then, the signal is counted by the counter circuit, and a count value of counted signals that is to be output from the counter circuit increases by 1 least significant bit (LSB).

A photon enters the APD during a period between times t3 and t4, but the switch is in an off state, and an applied voltage to the APD 201 does not have a potential difference at which avalanche multiplication can occur. Thus, a voltage level at the node A does not exceed the determination threshold value.

At the time t4, the control signal P_CLK changes from the high level to a low level, and the switch is turned on. A current compensating for a voltage drop from the drive voltage VL accordingly flows to the node A, and the voltage at the node A transitions to the original voltage level. At this time, because the voltage at the node A becomes equal to or larger than the determination threshold value at a time t5, a pulse signal at the node B is reversed from the high level to the low level.

At a time t6, the voltage level at the node A is statically settled at the original voltage level, and the control signal P_CLK changes from the low level to the high level. Accordingly, the switch is turned off. Subsequently, potentials at each node and signal lines also change in accordance with the control signal P_CLK and photon entrance as described using the times t1 to t6.

Hereinafter, a photoelectric conversion apparatus according to each exemplary embodiment will be described.

### <First Exemplary Embodiment>

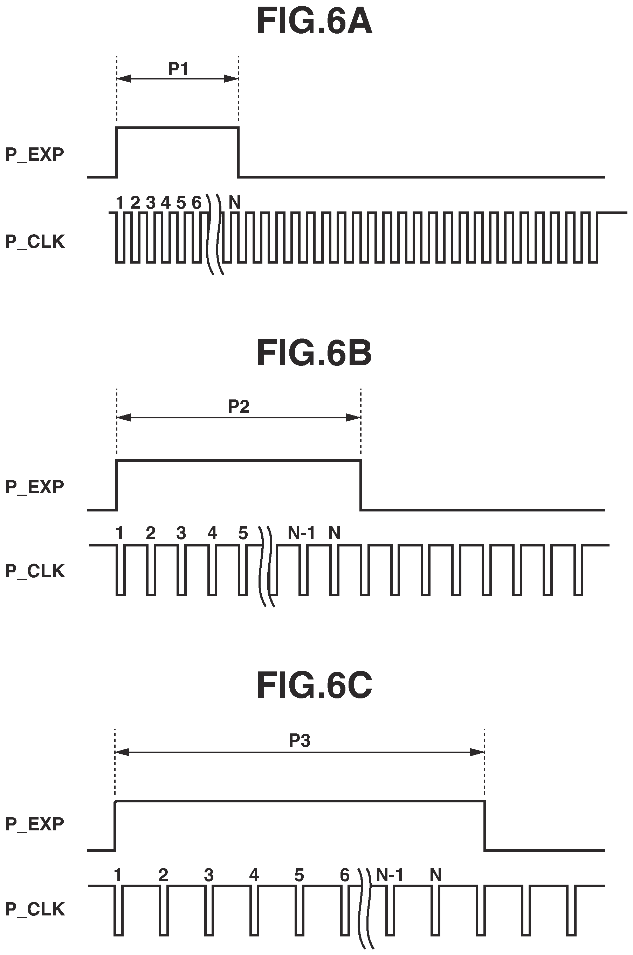

Figs. 6A to 6C are timing charts each illustrating a relationship between the exposure period P and the control signal P_CLK according to a first exemplary embodiment. Fig. 6A is a diagram illustrating a pulse signal of the control signal P_CLK output in a case where an exposure period is an exposure period P1. Fig. 6B is a diagram illustrating a pulse signal of the control signal P_CLK output in a case where an exposure period is an exposure period P2 longer than the exposure period P1. Fig. 6C is a diagram illustrating a pulse signal of the control signal P_CLK output in a case where an exposure period is an exposure period P3 longer than the exposure period P2.

In the present exemplary embodiment, the exposure period P refers to a period during which a mechanical shutter or an electronic shutter is opened, for example, and a non-exposure period refers to a period during which a mechanical shutter or an electronic shutter is closed, for example. In addition, the exposure period P may be defined by varying whether a photon signal can be acquired, by adjusting bias to be applied to the APD 201. The exposure period P refers to a period during which the APD 201 is in an operable state, and the APD and the signal processing circuit are in a signal-readable state. Here, the state in which the APD and the signal processing circuit are in a signal-readable state refers to a state in which avalanche multiplication can occur in the APD. It can also be said that the counter circuit is operating during the period. At this time, a period for the quench operation of an APD, which is a state in which the switch is turned off based on the photon entrance, constitutes a part of the operable state. On the other hand, a period during which light is shielded by a shutter, and a period during which an APD is controlled in such a manner that avalanche multiplication does not occur, irrespective of whether photons enter become a non-exposure period.

As illustrated in Figs. 6A to 6C, in the present exemplary embodiment, a pulse signal of the control signal P_CLK is changed in accordance with the exposure period P. A first exposure period and a second exposure period being a period different from the first exposure period are assumed. Control signals are controlled in such a manner that a value obtained by dividing the number of control signals P_CLK within the first exposure period by the first exposure period and multiplying the divided value by the first exposure period, and a value obtained by dividing the number of control signals P_CLK within the second exposure period by the second exposure period and multiplying the divided value by the first exposure period become different values. In the present exemplary embodiment, because the switch 202 is a PMOS transistor, the number of control signals P_CLK refers to the number of turned-off pulses within a predetermined exposure period.

In addition, the control signal P_CLK is controlled in such a manner that an average frequency of the control signal P_CLK within a first exposure period, and an average frequency of the control signal P_CLK within a second exposure period different from the first exposure period become different when comparison is made per unit time. Here, an average frequency of the control signal P_CLK within an exposure period refers to a frequency obtained by evenly averaging pulse signals within an exposure period. For example, in a case where pulse signals are densely arranged in an anterior half of an exposure period, and no pulse signal is arranged in a posterior half, a frequency adjusted in such a manner that pulse signals are averagely arranged over the entire period refers to an average frequency of the control signal P_CLK within the exposure period. Then, in the present exemplary embodiment, the control signal P_CLK is controlled in such a manner that the average frequency in the first exposure period and the average frequency in the second exposure period become different in a case where the average frequencies are compared between the first exposure period and the second exposure period. The unit time refers to a time during which at least two pulse signals of the control signal P_CLK are output.

In Figs. 6A to 6C, pulse signals of the control signal P_CLK are controlled in such a manner that the number of pulses of pulse signals within the exposure period P is the same even if the exposure period P changes. The number of pulses of the control signal P_CLK within the exposure period P1 illustrated in Fig. 6A is set to N. Also in the exposure period P2 illustrated in Fig. 6B, the number of pulses of the control signal P_CLK is set to N. Furthermore, also in the exposure period P3 illustrated in Fig. 6C, the number of pulses of the control signal P_CLK is set to N.

With the above-described configuration, an increase in power consumption generated in each pixel can be prevented. In addition, in a case where a signal processing unit includes a counter circuit, it becomes possible to execute clock drive that keeps an appropriate count upper limit.

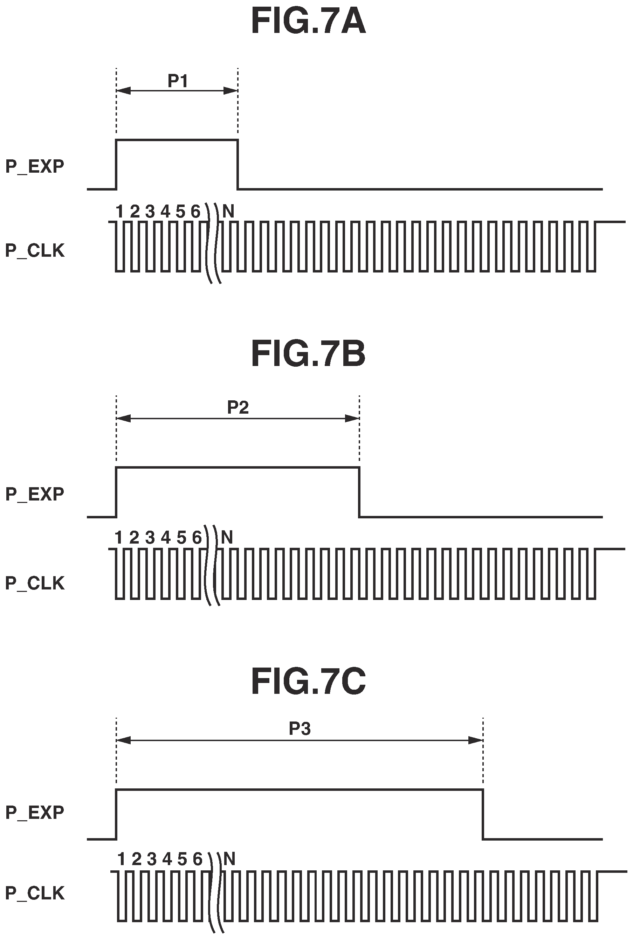

Hereinafter, the detailed description will be given while making comparison with a comparative configuration in Figs. 7A to 7C. Figs. 7A to 7C are timing charts each illustrating a relationship between the exposure period P and the control signal P_CLK according to a comparative configuration. In Figs. 7A to 7C, the components similar to those in Figs. 6A to 6C are assigned the same reference numerals as those in Figs. 6A to 6C, and the description thereof will be omitted.

In the comparative configuration illustrated in Figs. 7A to 7C, even if an exposure period changes, the cycle of the control signal P_CLK is the same. In the present exemplary embodiment, because the switch 202 is a PMOS transistor, the cycle of the control signal P_CLK refers to a period from the fall of a pulse to the next fall. For example, in both of the case where an exposure period is the exposure period P1 and the case where an exposure period is the exposure period P2, the cycle of the control signal P_CLK is the same. Accordingly, in the comparative configuration, if the exposure period P changes, the number of pulses of pulse signals within the exposure period P changes. In this configuration, depending on the exposure period, power consumption might involuntarily increase. Even if a clock frequency increases in a subsequent signal processing circuit, the result is not reflected, and unnecessary power might be consumed. For example, in a case where a signal processing circuit is a counter circuit, a clock frequency at a value larger than a readable counter upper limit is not read out as a signal. That is, at a value larger than a counter upper limit, even if a signal is read out by performing the quench operation and the recharge operation, a count value is not added in the counter circuit. Accordingly, at a value larger than a counter upper limit, unnecessary power consumption is generated. If a clock frequency is increased too much, the number of readable photons becomes smaller, and a dynamic range might decrease.

In contrast to this, as described above, by controlling the number of pulses of pulse signals of the control signal P_CLK in accordance with an exposure period, unnecessary power consumption can be reduced.

As illustrated in Figs. 6A to 6C, the cycle of the control signal P_CLK changes in accordance with an exposure period. For example, the cycle of the control signal P_CLK in the exposure period P1 is shorter than the cycle of the control signal P_CLK in the exposure period P2. In this manner, in Figs. 6A to 6C, even if an exposure period changes like the exposure period P1, the exposure period P2, and the exposure period P3, the number of pulses of the control signal P_CLK is controlled to always become N. With this configuration, an increase in power consumption can be reduced.

The number of pulses in an exposure period can be set to an arbitrary value. In a case where a subsequent signal processing circuit is a counter circuit, for example, the number of pulses is desirably set to a count upper limit of the counter circuit. With this configuration, it is possible to prevent the generation of unnecessary power consumption while preventing a decrease in dynamic range.

A first pulse width in the exposure period P1 and a first pulse width in the exposure period P2 are desirably the same. Here, the first pulse width refers to a period during which the switch 202 is turned on in accordance with the control signal P_CLK. In the present exemplary embodiment, because the switch 202 is a PMOS transistor, the first pulse width refers to a period during which the control signal P_CLK is at a low level (first level). As described above, a period during which the control signal P_CLK is at a high level (second level) is a period during which the switch is turned off, and the recharge operation is less likely to be performed in an APD. In this specification, a period during which the control signal P_CLK maintains a first level state will be described as the "first pulse width", and a period during which the control signal P_CLK maintains a second level state will be described as a "second pulse width". In Figs. 6A to 6C, the first pulse width in the exposure period P1 and the first pulse width in the exposure period P2 are the same, but the second pulse width in the exposure period P1 and the second pulse width in the exposure period P2 are different.

In contrast, a period during which the control signal P_CLK is at the low level is a period during which the switch is turned on, and the recharge operation is performed in an APD. If the period during which the control signal P_CLK is at the low level becomes longer, the recharge operation might be performed a plurality of times. As described with reference to Fig. 5, the potential at the node A drops in a state in which the potential at the node A is lower than the determination threshold value, a signal at the node B is not reversed, and the signal might fail to be properly read out as a signal value. Thus, by setting a period during which the recharge operation is performed in an APD, to a fixed period even if the cycle of pulse signals changes, the recharge operation is not performed a plurality of times during a period during which the control signal P_CLK is at the low level, and the number of undetectable photons can be reduced.

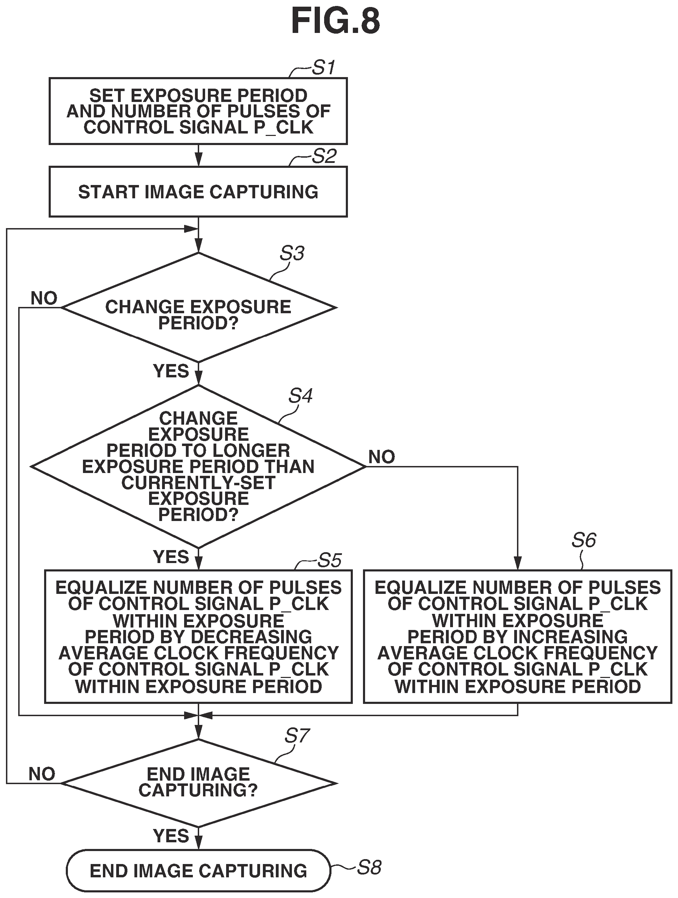

Fig. 8 illustrates an example of a flowchart of an operation of the photoelectric conversion apparatus according to the present exemplary embodiment.

In step S1, an exposure period and the number of pulses of the control signal P_CLK are set. In this example, a clock frequency of the control signal P_CLK is set. In step S2, image capturing is started. In step S3, whether to change an exposure period is determined. Whether to change an exposure period can be determined based on information (previous frame information) obtained from a previously-captured image. In the previous frame information, in a case where information obtained from an image is too bright, an exposure period is shortened, and in a case where information obtained from an image is too dark, an exposure period is prolonged. Aside from this, an exposure period can be switched manually or automatically.

In a case where it is determined in step S3 that an exposure period is to be changed, in step S4, whether to prolong the setting of an exposure period is determined. Inacase where it is determined in step S3 that an exposure period is to be changed, the processing proceed to step S4. In a case where it is determined in step S3 that an exposure period is not to be changed, the processing proceed to step S7.

In a case where it is determined in step S4 that the setting of an exposure period is to be prolonged, in step S5, an average clock frequency of the control signal P_CLK within an exposure period is decreased. At this time, control is performed in such a manner that the number of pulses of the control signal P_CLK within an exposure period remains unchanged after the exposure period is changed, from the number of pulses of the control signal P_CLK within the unchanged exposure period. In a case where it is determined in step S4 that the setting of an exposure period is not to be prolonged (is to be shortened), in step S6, an average clock frequency of the control signal P_CLK within an exposure period is set to a higher average clock frequency. Also in this case, control is performed in such a manner that the number of pulses of the control signal P_CLK within an exposure period remains unchanged from the number of pulses of the control signal P_CLK within the unchanged exposure period.

After step S5 or S6, the processing proceeds to step S7, and whether to end image capturing is determined. In a case where it is determined in step S7 that the image capturingistobeended,instepS8,imagecapturingisended. Inacasewhereitis determined in step S7 that image capturing is not to be ended, the processing returns to step S3, and the processing in steps S3 to S7 is repeated. Then, if it is determined in step S7 that image capturing is to be ended, in step S8, image capturing is ended.

An operation can be performed in accordance with the above-described flowchart.

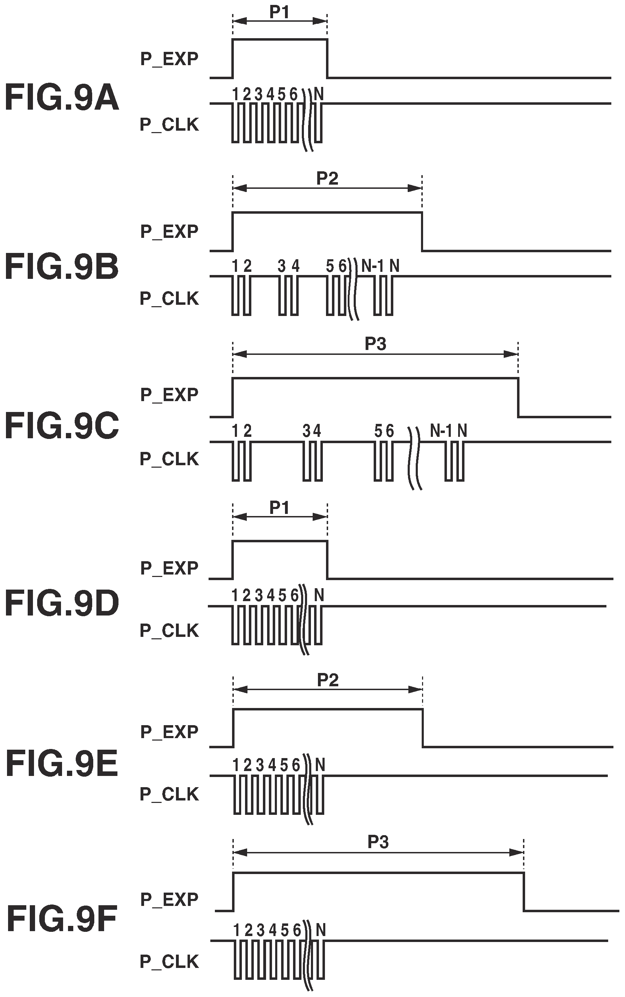

Figs. 9A to 9F illustrate a modified example of a timing chart. In Figs. 6A to 6C, the pulse signal P_CLK is input at a fixed cycle, but the configuration is not limited to this. As illustrated in Figs. 9A to 9C, the pulse signal P_CLK may be input while varying a pulse cycle. In Figs. 9A to 9C, a cycle is varied for each pulse signal, but a cycle may be varied for every three or four or more pulse signals.

In addition, as illustrated in Figs. 9D to 9F, in the same period as the exposure period P1, the number of pulses in the exposure period P2 and the number of pulses in the exposure period P3 may be the same number of pulses as the number of pulses in the exposure period P1. More specifically, a configuration in which the control signals P_CLK are consecutively supplied to the switch in an anterior half of the exposure period P2, and the control signal P_CLK is not supplied in a posterior half of the exposure period P2 may be employed. Also in such a case, if the number of pulses in the exposure period P2 and the number of pulses in the exposure period P1 are the same, an effect of the present exemplary embodiment can be obtained. Similarly, if the number of pulses in the exposure period P3 and the number of pulses in the exposure period P1 are the same, an effect of the present exemplary embodiment can be obtained.

### <Second Exemplary Embodiment>

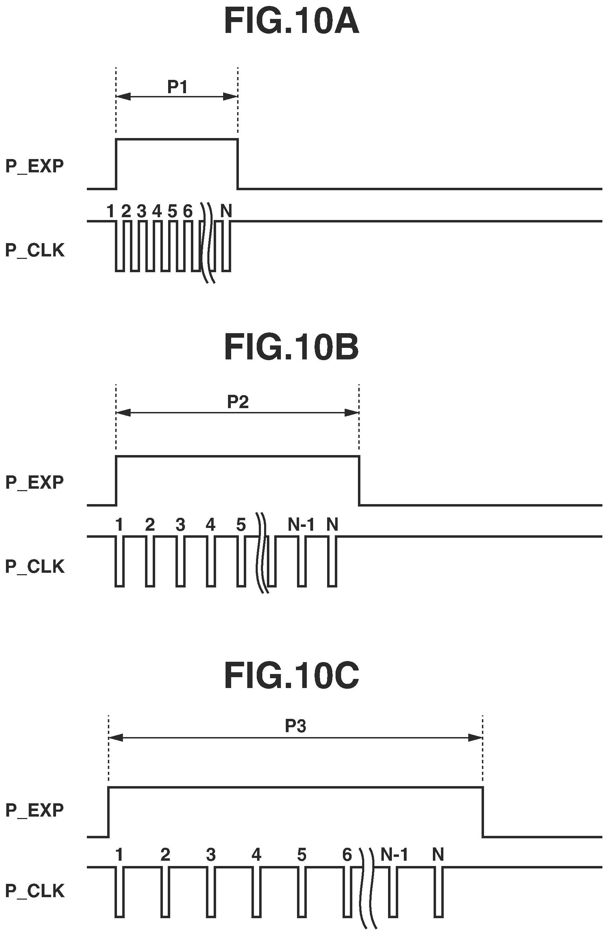

Figs. 10A to 10C are timing charts each illustrating a relationship between the exposure period P and the control signal P_CLK according to a second exemplary embodiment. Fig. 10A is a diagram illustrating a pulse signal of the control signal P_CLK output in a case where an exposure period is an exposure period P1. Fig. 10B is a diagram illustrating a pulse signal of the control signal P_CLK output in a case where an exposure period is an exposure period P2 longer than the exposure period P1. Fig. 10C is a diagram illustrating a pulse signal of the control signal P_CLK output in a case where an exposure period is an exposure period P3 longer than the exposure period P2.

A photoelectric conversion apparatus according to the present exemplary embodiment differs from that in the first exemplary embodiment in that the photoelectric conversion apparatus stops generating a pulse signal of the control signal P_CLK at a timing at which an exposure period changes to a non-exposure period. Because the present exemplary embodiment is substantially similar to the first exemplary embodiment except for this point and points to be described below, the components similar to those in the first exemplary embodiment are assigned the same reference numerals, and the description thereof will be sometimes omitted.

In the present exemplary embodiment, at an end timing of an exposure period, the control signal P_CLK is stopped at the low level. That is, the switch is kept in an off state. Then, at a start timing of an exposure period, the level of the control signal P_CLK is changed to the high level.

Because no photon enters an APD during a non-exposure period, it becomes unnecessary to control on/off of the switch. Accordingly, by avoiding changing the control signal P_CLK for controlling on/off of the switch, power consumption generated by turning on/off the switch can be suppressed.

The end timing of an exposure period may be controlled in synchronization with a shutter.

In addition, as illustrated in Figs. 10A to 10C, it is desirable for reduction of power consumption to stop a pulse signal of the control signal P_CLK simultaneously with the end timing of an exposure period, but the stop timing may be slightly shifted from the end timing of an exposure period.

According to the present exemplary embodiment, similarly to the first exemplary embodiment, an increase in power consumption can be suppressed. In addition, because the number of times the switch is turned on/off can be reduced as compared with the first exemplary embodiment, it becomes possible to further suppress power consumption of the photoelectric conversion apparatus.

### <Third Exemplary Embodiment>

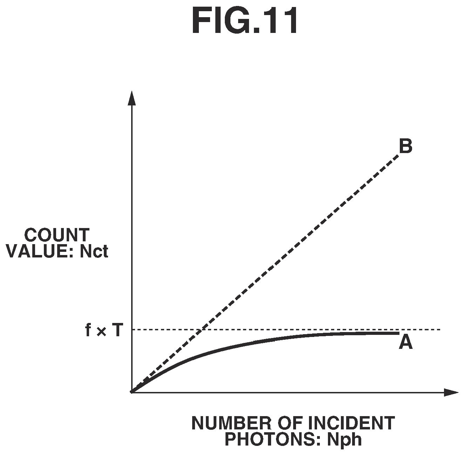

The correction of a count value Nct obtained in the photoelectric conversion apparatus according to the first or the second exemplary embodiment will be described with reference to Fig. 11 to Fig. 13.

Fig. 11 is a diagram illustrating a relationship between the number of incident photons Nph in each pixel of the photoelectric conversion apparatus, and the count value Nct. Here, the number of incident photons Nph is the number of photons actually entering each pixel per exposure period T (the number of incident photons). In addition, the count value Nct is a count value of a pulse signal output from the waveform shaping unit 210 that is counted by the counter circuit 211. Here, when a frequency of the control signal P_CLK is denoted by f, the number of pulses of the control signal P_CLK within an exposure period T becomes equal to f × T.

In a case where the switch 202 of each pixel is controlled based on a cyclic pulse, the count value Nct of each pixel exhibits a property as indicated by a curve A in Fig. 11. More specifically, the count value Nct increases in accordance with an increase of the number of incident photons Nph, and is counted up to the ceiling of the number of pulses f × T. Because the recharge operation is performed once for one pulse of the control signal P_CLK, the number photons that can be counted for one cycle of the control signal P_CLK is only one. Thus, in a case where a plurality of photons enter for one cycle of the control signal P_CLK, second and subsequent photons in each cycle are not counted. Accordingly, under a high illumination environment, the number of photons that are not counted even if the photons enter a pixel increases, and a discrepancy arises between the count value Nct and the number of actual incident photons Nph.

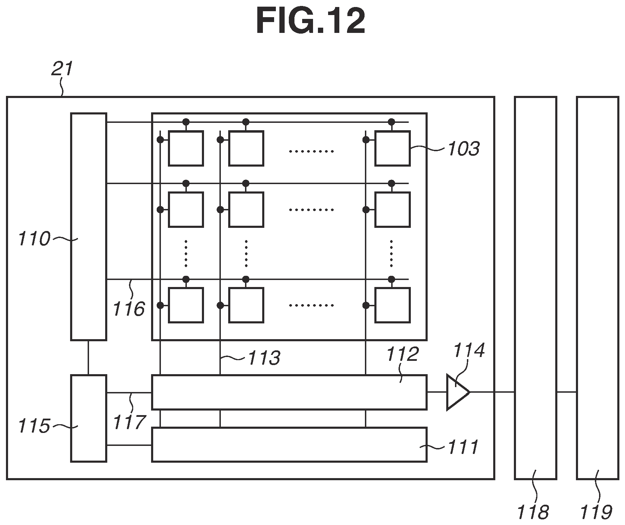

In view of the foregoing, in the present exemplary embodiment, the correction of converting the count value Nct into a value equivalent to the number of actual incident photons Nph is performed. The correction is performed by a correction circuit 118 connected with the circuit substrate 21. The correction circuit 118 may be provided on the outside of the photoelectric conversion apparatus 100 as illustrated in Fig. 12, or may be provided inside the photoelectric conversion apparatus 100 (e.g., the signal processing circuit 103). An external output circuit 119 is also provided as illustrated in Fig. 12. The relationship between the count value Nct and the number of incident photons Nph is represented by the following equation that is based on a natural logarithm. $Nct = f \times T \times \left(1-exp\left(-Nph/\left(f\times T\right)\right)\right)$ (1)

In other words, in the correction circuit 118, when the count value Nct, the frequency f of the pulse signal, and a length T of an exposure period are regarded as explanatory variables, and the number of incident photons Nph is regarded as an objective variable, the explanatory variables and the objective variable are represented by a relational expression that is based on a natural logarithm.

The corrected count value Nct can be indicated by a dotted line B in Fig. 11. By performing the correction, the count value indicated by the curve A exhibiting a nonlinear property with respect to the number of incident photons can be corrected to the count value indicated by the dotted line B having linearity with respect to the number of incident photons.

Here, because a correction formula is determined based on a value of f × T, even if a value of the exposure period T is defined for each of different frequencies f of the control signal P_CLK, as long as the combination of the frequency f and the exposure period T is a combination that keeps f × T constant, the value of the count value Nct with respect to the number of incident photons Nph does not change.

In addition, in a case where two types of frequencies of the control signal P_CLK mixedly exist during one exposure period, the count value Nct can be corrected by the following equation. $Nct = {f}_{1} \times {T}_{1} \times \left(1-exp\left(-{Nph}_{1}/\left({f}_{1}\times {T}_{1}\right)\right)\right) + {f}_{2} \times {T}_{2} \times \left(1-exp\left(-{Nph}_{2}/\left({f}_{2}\times {T}_{2}\right)\right)\right)$ (2)

At this time, T₁ denotes a period during which a pulse signal operates at a first frequency f₁, T₂ denotes a period during which a pulse signal operates at a second frequency f₂, and T₁ + T₂ corresponds to the exposure period T. In addition, Nph₁ denotes the number of incident photons in the period T₁, and Nph₂ denotes the number of incident photons in the period T₂. The numbers of incident photons Nph₁ and Nph₂ can be represented by the following equations. ${Nph}_{1} = Nph \times {T}_{1} / \left({T}_{1}+{T}_{2}\right)$ (3) ${Nph}_{2} = Nph \times {T}_{2} / \left({T}_{1}+{T}_{2}\right)$ (4)

In this manner, the number of incident photons is determined by a ratio of an exposure period at each frequency with respect to the total exposure period T.

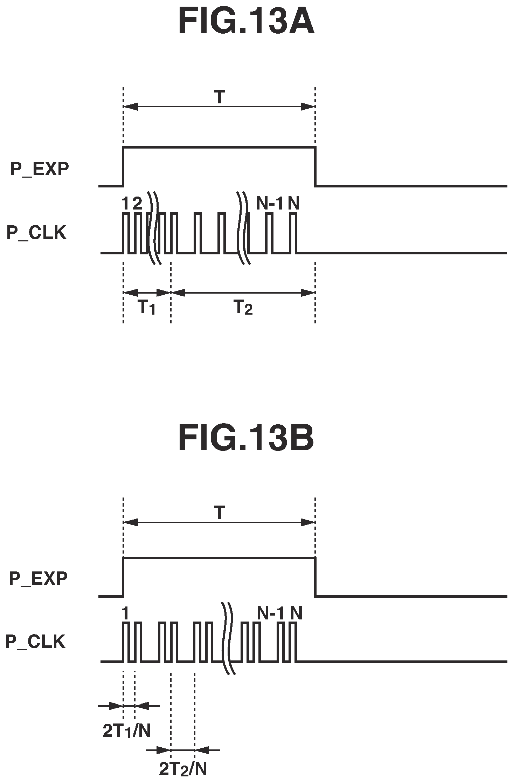

Here, as illustrated in Figs. 13A and 13B, a case where a plurality of frequencies mixedly exist within an exposure period will be considered. For example, as illustrated in Fig. 13A, pulse signals may be collectively input for each frequency in such a manner that the frequency of pulse signals input in an anterior half of an exposure period becomes the frequency f₁, and the frequency of pulse signals input in a posterior half becomes the frequency f₂. In addition, as illustrated in Fig. 13B, two pulses at different frequencies may alternately continue. A pulse signal at the frequency f₁ and a pulse signal at the frequency f₂ may alternately continue for each pair of pulse signals. Figs. 13A and 13B illustrate cases where pulse signals at two types of frequencies mixedly exist within an exposure period, but pulse signals at three or more types of frequencies may mixedly exist.

In this manner, by pulse signals at a plurality of types of frequencies mixedly existing within an exposure period, as compared with a case where only pulse signals at a low frequency are input, a slope of a count value under high illumination becomes larger. Thus, even under high illumination, the gradation property of the count value is maintained, and a dynamic range can be extended as compared with a case where the number of types of frequencies of pulse signals is one.

Furthermore, in a case where n types of frequencies of the control signal P_CLK mixedly exist within an exposure period, a correction equation is represented by the following equation, where n is a natural number equal to or larger than 2. 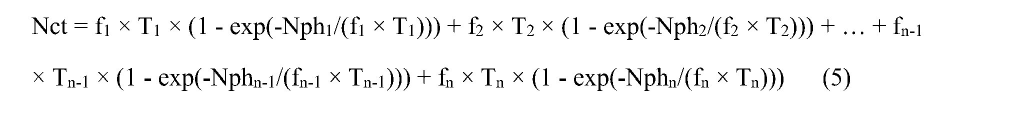 Nct = f1 × T1 × (1 - exp(-Nph1/(f1 × T1))) + f2 × T2 × (1 - exp(-Nph2/(f2 × T2))) + ... + fn-1 × Tn-1 × (1 - exp(-Nphn-1/(fn-1 × Tn-1))) + fn × Tn × (1 - exp(-Nphn/(fn × Tn))) (5)

The sum of periods during which pulse signals at the frequencies are input is equal to the exposure period T. In addition, the numbers of incident photons during the periods during which pulse signals at the frequencies are input are represented by the following equations. ${Nph}_{1} = Nph \times {T}_{1} / \left({T}_{1}+{T}_{2}+…+{T}_{n - 1}+{T}_{n}\right)$ (6) ${Nph}_{2} = Nph \times {T}_{2} / \left({T}_{1}+{T}_{2}+…+{T}_{n - 1}+{T}_{n}\right)$ (7) ${Nph}_{n - 1} = Nph \times {T}_{n - 1} / \left({T}_{1}+{T}_{2}+…+{T}_{n - 1}+{T}_{n}\right)$ (8) ${Nph}_{n} = Nph \times {T}_{n} / \left({T}_{1}+{T}_{2}+…+{T}_{n - 1}+{T}_{n}\right)$ (9)

The number of incident photons is determined by a ratio of an exposure period at each frequency with respect to the total exposure period T.

The correction performed by the correction circuit 118 is not limited to a case where the correction represented by the above-described equation is performed on each count value as occasion arises. For example, the correction circuit 118 may include a three-dimensional table defining a combination of values of the exposure period T, the frequency f of the pulse signal, and the count value Nct. By selecting a value closest to a measurement value from numerical values in the table included in the correction circuit 118, the number of incident photons Nph can be roughly estimated. At this time, numerical values in the table are set by a relational expression that is based on a natural logarithm corresponding to the combination of the frequency f and the exposure period T, similarly to the above-described equation.

The correction of the count value is not limited to this. By the correction circuit 118 performing other types of correction simultaneously with the correction, the number of correction steps may be reduced. For example, so-called gamma correction of adjusting the brightness of an image formed based on a count value may be performed in preparation for the display on a display.

### <Fourth Exemplary Embodiment>

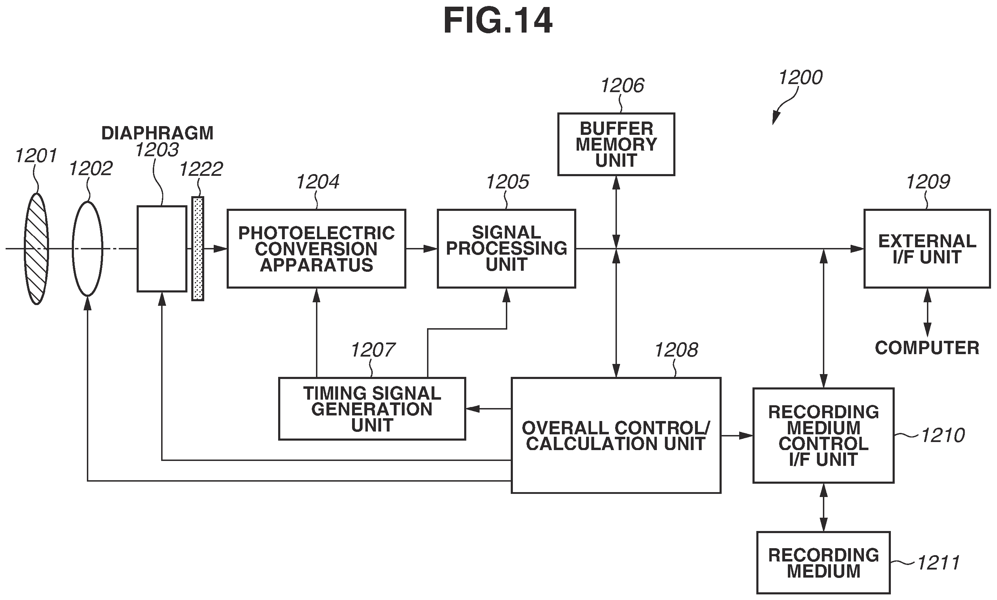

Fig. 14 is a block diagram illustrating a configuration of an optical detection system 1200 according to the present exemplary embodiment. The optical detection system 1200 according to the present exemplary embodiment includes a photoelectric conversion apparatus 1204. Here, any of the photoelectric conversion apparatuses described in the above-described exemplary embodiments can be applied as the photoelectric conversion apparatus 1204. The optical detection system 1200 can be used as an image capturing system, for example. Specific examples of image capturing systems include a digital still camera, a digital camcorder, and a monitoring camera. Fig. 14 illustrates an example in which a digital still camera is used as the optical detection system 1200.

The optical detection system 1200 illustrated in Fig. 14 includes the photoelectric conversion apparatus 1204, a lens 1202 that forms an optical image of a subject on the photoelectric conversion apparatus 1204, a diaphragm 1203 for varying an amount of light passing through the lens 1202, and a barrier 1201 for protecting the lens 1202. The lens 1202 and the diaphragm 1203 serve as an optical system that condenses light onto the photoelectric conversion apparatus 1204. A shutter is arranged between the diaphragm 1203 and the photoelectric conversion apparatus 1204. By opening and closing the shutter, an exposure period of the photoelectric conversion apparatus is controlled.

The optical detection system 1200 further includes a signal processing unit 1205 that processes an output signal output from the photoelectric conversion apparatus 1204. The signal processing unit 1205 performs an operation of signal processing of outputting input signals after performing various types of correction and compression on the input signals as necessary. The optical detection system 1200 further includes a buffer memory unit 1206 for temporarily storing image data, and an external interface unit (external I/F unit) 1209 for communicating with an external computer or the like. The optical detection system 1200 further includes a recording medium 1211 such as a semiconductor memory for recording or reading out captured image data, and a recording medium control interface unit (recording medium control I/F unit) 1210 for performing recording onto or readout from the recording medium 1211. The recording medium 1211 may be built into the optical detection system 1200, or may be detachably attached to the optical detection system 1200. In addition, communication with the recording medium 1211 from the recording medium control I/F unit 1210 and communication from the external I/F unit 1209 may be wirelessly performed.

The optical detection system 1200 further includes an overall control/calculation unit 1208 that performs various types of calculation and controls the entire digital still camera, and a timing signal generation unit 1207 that outputs various timing signals to the photoelectric conversion apparatus 1204 and the signal processing unit 1205. Here, the timing signals and the like may be input from the outside. The optical detection system 1200 is only required to include at least the photoelectric conversion apparatus 1204 and the signal processing unit 1205 that processes an output signal output from the photoelectric conversion apparatus 1204. The timing signal generation unit 1207 may be mounted on a photoelectric conversion apparatus. The overall control/calculation unit 1208 and the timing signal generation unit 1207 may be configured to execute a part or all of control functions of the photoelectric conversion apparatus 1204.

The photoelectric conversion apparatus 1204 outputs an image signal to the signal processing unit 1205. The signal processing unit 1205 outputs image data after performing predetermined signal processing on the image signal output from the photoelectric conversion apparatus 1204. The signal processing unit 1205 generates an image using the image signal. In addition, the signal processing unit 1205 may perform distance measurement calculation on a signal output from the photoelectric conversion apparatus 1204. The signal processing unit 1205 and the timing signal generation unit 1207 may be mounted on a photoelectric conversion apparatus. That is, the signal processing unit 1205 and the timing signal generation unit 1207 may be provided on a substrate on which a pixel is arranged, or may be provided on another substrate. By forming an image capturing system using the photoelectric conversion apparatus according to each of the above-described exemplary embodiments, an image capturing system that can acquire a higher-quality image can be realized.

### <Fifth Exemplary Embodiment>

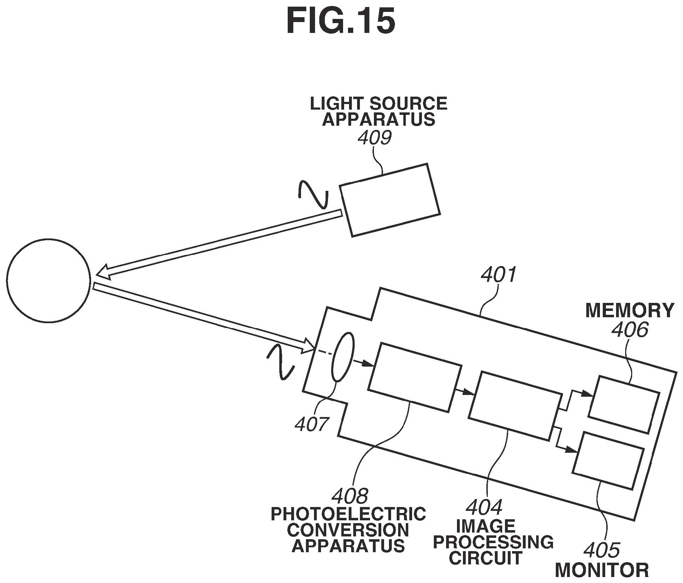

Fig. 15 is a block diagram illustrating a configuration example of a distance image sensor being an electronic device that uses the photoelectric conversion apparatus described in the above-described exemplary embodiment.

As illustrated in Fig. 15, a distance image sensor 401 includes an optical system 407, a photoelectric conversion apparatus 408, an image processing circuit 404, a monitor 405, and a memory 406. Then, the distance image sensor 401 can acquire a distance image corresponding to a distance to a subject, by receiving light (modulated light or pulse light) that has been projected from a light source apparatus 409 toward the subject, and reflected on the front surface of the subject.

The optical system 407 includes one or a plurality of lenses, and forms an image on a light receiving surface (sensor portion) of the photoelectric conversion apparatus 408 by guiding image light (incident light) from the subject to the photoelectric conversion apparatus 408.

The photoelectric conversion apparatus according to any of the above exemplary embodiments is applied as the photoelectric conversion apparatus 408, and a distance signal indicating a distance obtained from a light receiving signal output from the photoelectric conversion apparatus 408 is supplied to the image processing circuit 404.

The image processing circuit 404 performs image processing of constructing a distance image, based on the distance signal supplied from the photoelectric conversion apparatus 408. Then, a distance image (image data) obtained by the image processing is supplied to the monitor 405 and displayed thereon, or supplied to the memory 406 and stored (recorded) therein.

By applying the above-described photoelectric conversion apparatus, the distance image sensor 401 having the above-described configuration can acquire a more accurate distance image, for example, in accordance with characteristic enhancement of a pixel.

### <Sixth Exemplary Embodiment>

The technique according to the present disclosure (the present technique) can be applied to various products. For example, the technique according to the present disclosure may be applied to an endoscopic operation system.

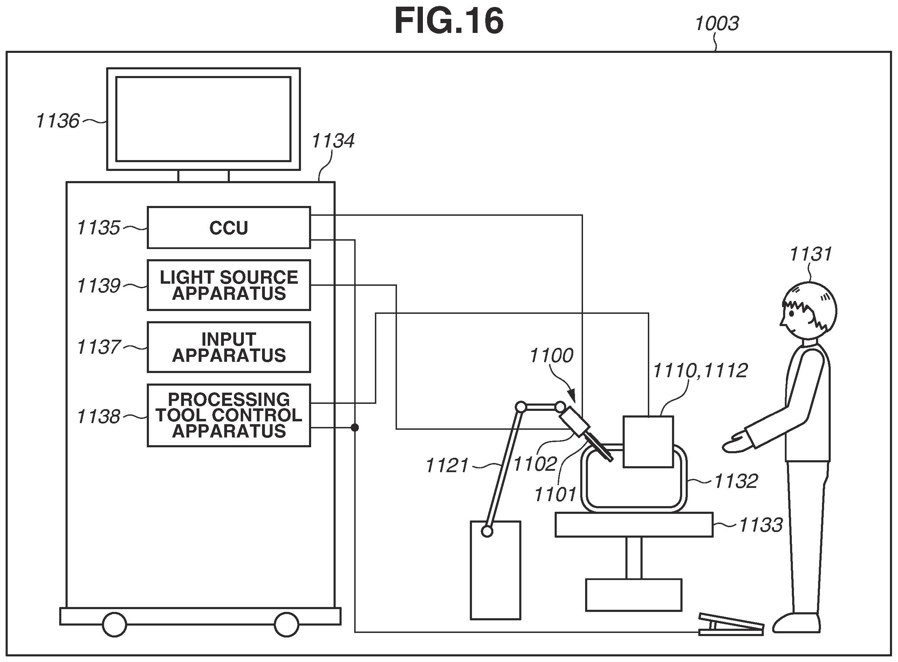

Fig. 16 is a diagram illustrating an example of a schematic configuration of an endoscopic operation system to which the technique according to the present disclosure (the present technique) can be applied.

Fig. 16 illustrates a state in which an operator (doctor) 1131 is performing an operation on a patient 1132 lying on a patient bed 1133, using an endoscopic operation system 1003. As illustrated in Fig. 16, the endoscopic operation system 1003 includes an endoscope 1100, a surgical tool 1110, and a cart 1134 equipped with various apparatuses for an endoscopic operation.

The endoscope 1100 includes a lens barrel 1101 having a region to be inserted into a body cavity of the patient 1132 by a predetermined length from a distal end, and a camera head 1102 connected to a proximal end of the lens barrel 1101. In the example illustrated in Fig. 16, the endoscope 1100 formed as a so-called rigid scope including the rigid lens barrel 1101 is illustrated, but the endoscope 1100 may be formed as a so-called flexible scope including a flexible lens barrel.

An opening portion into which an objective lens is fitted is provided at the distal end of the lens barrel 1101. A light source apparatus 1139 is connected to the endoscope 1100, and light generated by the light source apparatus 1139 is guided to the distal end of the lens barrel 1101 by a light guide extended inside the lens barrel 1101, and emitted onto an observation target in the body cavity of the patient 1132 via the objective lens. The endoscope 1100 may be a direct view endoscope, or may be an oblique view endoscope or a lateral view endoscope.

An optical system and a photoelectric conversion apparatus are provided inside the camera head 1102. Reflected light (observation light) from an observation target is condensed by the optical system to the photoelectric conversion apparatus. The observation light is photoelectrically-converted by the photoelectric conversion apparatus, and an electric signal corresponding to the observation light, i.e., image signal corresponding to an observed image is generated. The photoelectric conversion apparatus according to any of the above exemplary embodiments can be used as the photoelectric conversion apparatus. The image signal is transmitted to a camera control unit (CCU) 1135 as RAW data.

The CCU 1135 includes a central processing unit (CPU) or a graphics processing unit (GPU), and comprehensively controls operations of the endoscope 1100 and a display device 1136. Furthermore, the CCU 1135 receives an image signal from the camera head 1102, and performs various types of image processing for displaying an image that is based on the image signal, such as development processing (demosaic processing), for example, on the image signal.

Based on the control from the CCU 1135, the display device 1136 displays an image that is based on an image signal on which image processing has been performed by the CCU 1135.

The light source apparatus 1139 includes a light source such as a light emitting diode (LED), for example, and supplies irradiating light for capturing an image of an operative site, to the endoscope 1100.

An input apparatus 1137 is an input interface for the endoscopic operation system 1003. A user can input various types of information and instructions to the endoscopic operation system 1003 via the input apparatus 1137.

A processing tool control apparatus 1138 controls the driving of an energy processing tool 1112 for cauterizing or cutting a tissue, or sealing a blood vessel.

The light source apparatus 1139 that supplies irradiating light for capturing an image of an operative site, to the endoscope 1100 can include, for example, an LED, a laser light source, or a white light source including a combination of these. Inacase where a white light source includes a combination of RGB laser light sources, because an output intensity and an output timing of each color (each wavelength) can be controlled highly accurately, white balance of a captured image can be adjusted in the light source apparatus 1139. In addition, in this case, by emitting laser light from each RGB laser light source onto an observation target in a time division manner, and controlling the driving of an image sensor of the camera head 1102 in synchronization with the emission timing, an image corresponding to each of RGB can also be captured in a time division manner. According to the method, a color image can be obtained without providing a color filter in the image sensor.

In addition, the driving of the light source apparatus 1139 may be controlled in such a manner as to change the intensity of light to be output, every predetermined time. By acquiring images in a time division manner by controlling the driving of the image sensor of the camera head 1102 in synchronization with the change timing of the light intensity, and combining the images, it is possible to generate a high dynamic range image without so-called underexposure and overexposure.

The light source apparatus 1139 may be configured to supply light in a predetermined wavelength band adapted to special light observation. In the special light observation, for example, wavelength dependency of light absorption in body tissues is utilized. Specifically, by emitting light in a narrower band as compared with irradiating light (i.e., white light) in normal observation, an image of a predetermined tissue such as a blood vessel in a superficial portion of a mucous membrane is captured with high contrast. Alternatively, in special light observation, fluorescent observation of obtaining an image by fluorescence generated by emitting excitation light may be performed. In the fluorescent observation, fluorescence from a body tissue can be observed by emitting excitation light onto the body tissue, or a fluorescent image can be obtained by locally injecting reagent such as indocyanine green (ICG) into a body tissue and emitting excitation light corresponding to a fluorescence wavelength of the reagent, onto the body tissue. The light source apparatus 1139 can be configured to supply narrow-band light and/or excitation light adapted to such special light observation.

### <Seventh Exemplary Embodiment>

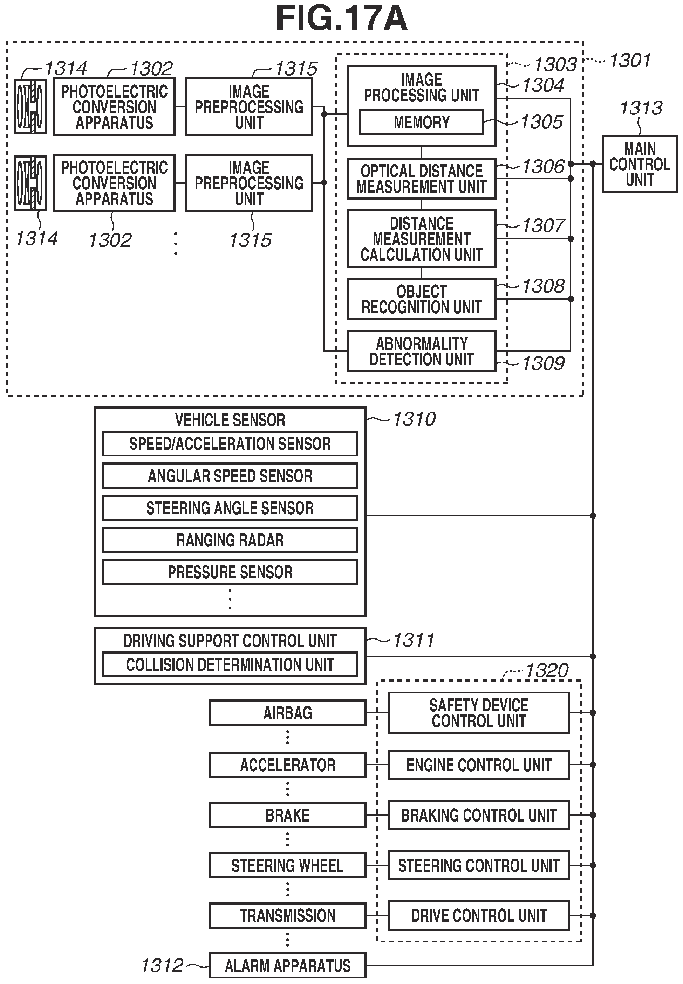

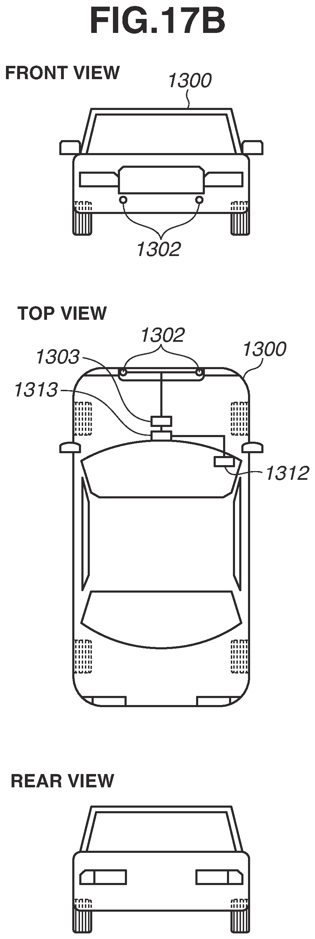

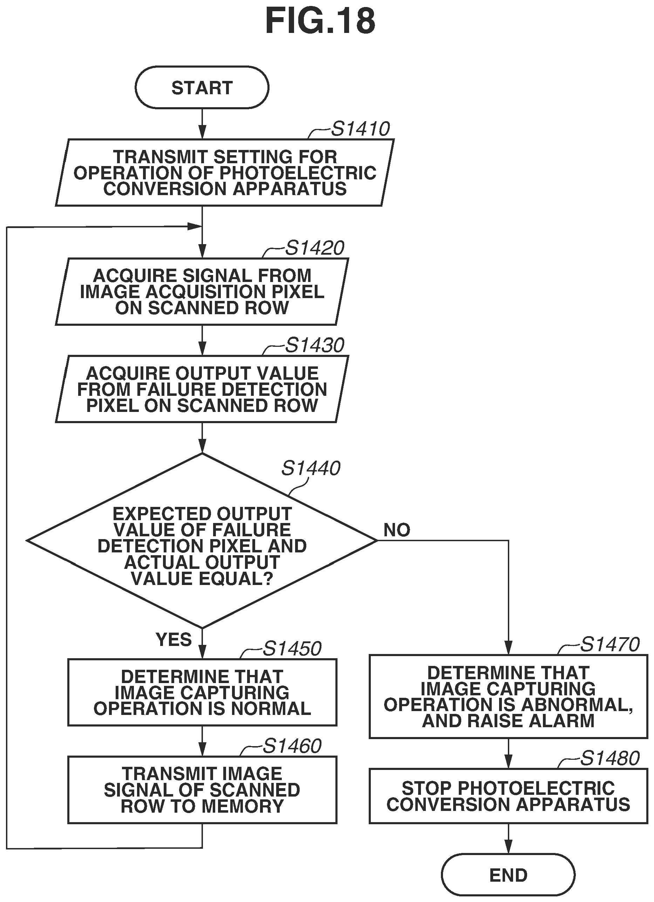

An optical detection system and a movable body according to the present exemplary embodiment will be described with reference to Figs. 17A, 17B, and 18. Figs. 17A and 17B are schematic diagrams illustrating a configuration example of an optical detection system and a movable body according to the present exemplary embodiment. Fig. 18 is a flowchart illustrating an operation of an optical detection system according to the present exemplary embodiment. In the present exemplary embodiment, an in-vehicle camera will be described as an example of an optical detection system.

Figs. 17A and 17B illustrate an example of a vehicle system and an optical detection system performing image capturing that is mounted in the vehicle system. An optical detection system 1301 includes a photoelectric conversion apparatus 1302, an image preprocessing unit 1315, an integrated circuit 1303, and an optical system 1314. The optical system 1314 forms an optical image of a subject on the photoelectric conversion apparatus 1302. The photoelectric conversion apparatus 1302 converts the optical image of the subject that has been formed by the optical system 1314, into an electric signal. The photoelectric conversion apparatus 1302 is the photoelectric conversion apparatus of any of the above-described each exemplary embodiment. The image preprocessing unit 1315 performs predetermined signal processing on a signal output from the photoelectric conversion apparatus 1302. The function of the image preprocessing unit 1315 may be incorporated into the photoelectric conversion apparatus 1302. In the optical detection system 1301, at least two sets each including the optical system 1314, the photoelectric conversion apparatus 1302, and the image preprocessing unit 1315 are provided, and output from the image preprocessing unit 1315 of each set is input to the integrated circuit 1303.

The integrated circuit 1303 is an integrated circuit intended for image capturing systems, and includes an image processing unit 1304 including a memory 1305, an optical distance measurement unit 1306, a distance measurement calculation unit 1307, an object recognition unit 1308, and an abnormality detection unit 1309. The image processing unit 1304 performs image processing such as development processing and defect correction on an output signal of the image preprocessing unit 1315. The memory 1305 is a primary storage of captured images, and stores a defect position of an image capturing pixel. The optical distance measurement unit 1306 performs focusing and distance measurement of a subject. The distance measurement calculation unit 1307 calculates distance measurement information from a plurality of pieces of image data acquired by a plurality of photoelectric conversion apparatuses 1302. The object recognition unit 1308 recognizes a subject such as a vehicle, a road, a sign, or a person. If the abnormality detection unit 1309 detects an abnormality of the photoelectric conversion apparatus 1302, the abnormality detection unit 1309 issues an alarm indicating the abnormality, to a main control unit 1313.

The integrated circuit 1303 may be implemented by dedicatedly-designed hardware, may be implemented by a software module, or may be implemented by the combination of these. In addition, the integrated circuit 1303 may be implemented by a field programmable gate array (FPGA) or an application specific integrated circuit (ASIC), or may be implemented by the combination of these.

The main control unit 1313 comprehensively controls operations of the optical detection system 1301, a vehicle sensor 1310, a control unit 1320, and the like. A method in which the main control unit 1313 is not included, and the optical detection system 1301, the vehicle sensor 1310, and the control unit 1320 individually include communication interfaces, and the optical detection system 1301, the vehicle sensor 1310, and the control unit 1320 individually perform transmission and reception of control signals via a communication network (for example, controller area network (CAN) standard) can also be employed.

The integrated circuit 1303 has a function of receiving control signals from the main control unit 1313 or transmitting control signals and setting values to the photoelectric conversion apparatus 1302

### by a control unit of itself.

The optical detection system 1301 is connected to the vehicle sensor 1310, and can detect an own vehicle running state such as a vehicle speed, a yaw rate, or a steering angle, and an own vehicle external environment, and states of other vehicles and obstacles. The vehicle sensor 1310 also serves as a distance information acquisition unit that acquires distance information indicating a distance to a target object. The optical detection system 1301 is also connected to a driving support control unit 1311 that performs various types of driving support such as automatic steering, automatic circumambulation, and a collision prevention function. In particular, as for a collision determination function, based on detection results of the optical detection system 1301 and the vehicle sensor 1310, collision with another vehicle or an obstacle is estimated and determined. With this configuration, in a case where collision is estimated, avoidance control is performed, and a safety device is activated when collision occurs.

The optical detection system 1301 is also connected to an alarm apparatus 1312 that raises an alarm to a driver based on a determination result obtained by a collision determination unit. For example, in a case where the determination result obtained by the collision determination unit indicates high collision likelihood, the main control unit 1313 performs vehicle control for avoiding collision or reducing damages by braking, releasing an accelerator, or suppressing engine output. The alarm apparatus 1312 issues an alarm to a user by sounding an alarm such as sound, displaying warning information on a display unit screen of a car navigation system or a meter panel, or vibrating a seatbelt or a steering wheel.

In the present exemplary embodiment, the optical detection system 1301 captures an image of the periphery of the vehicle such as the front side or the rear side, for example. Fig. 17B illustrates an arrangement example of the optical detection system 1301 for capturing an image of a vehicle front side by the optical detection system 1301.

Two photoelectric conversion apparatuses 1302 are arranged in an anterior part of a vehicle 1300. Specifically, for acquisition of distance information between the vehicle 1300 and a subject target object, and determination of collision likelihood, it is desirable that the two photoelectric conversion apparatuses 1302 are line-symmetrically arranged with respect to a symmetrical axis corresponding to a center line with respect to a traveling direction or an external form (for example, vehicle width) of the vehicle 1300. In addition, the photoelectric conversion apparatuses 1302 are desirably arranged in such a manner as not to block a viewing field of a driver when the driver visually checks an external situation of the vehicle 1300 from a driver's seat. The alarm apparatus 1312 is desirably arranged in such a manner as to easily enter the viewing field of the driver.

Next, a failure detection operation of the photoelectric conversion apparatus 1302 in the optical detection system 1301 will be described with reference to Fig. 18. The failure detection operation of the photoelectric conversion apparatus 1302 is executed in accordance with steps S1410 to S1480 illustrated in Fig. 18.

Step S1410 is a step for making a startup setting of the photoelectric conversion apparatus 1302. More specifically, a setting for an operation of the photoelectric conversion apparatus 1302 is transmitted from the outside (for example, the main control unit 1313) of the optical detection system 1301 or the inside of the optical detection system 1301, and an image capturing operation and a failure detection operation of the photoelectric conversion apparatus 1302 are started.

Subsequently, in step S1420, a pixel signal is acquired from an effective pixel. In addition, in step S1430, an output value from a failure detection pixel provided for failure detection is acquired. The failure detection pixel includes a photoelectric conversion element similarly to the effective pixel. A predetermined voltage is written into the photoelectric conversion element. The failure detection pixel outputs a signal corresponding to the voltage written into the photoelectric conversion element. The processing in step S1420 and the processing in step S1430 may be executed in a reverse order.

Subsequently, in step S1440, whether an expected output value from the failure detection pixel and an actual output value from the failure detection pixel are equal is determined. In a case where it is determined as a result of the equality determination in step S1440 that the expected output value and the actual output value are equal, the processing proceeds to step S1450. In step S1450, it is determined that an image capturing operation is normally performed, and the processing proceeds to step S1460. In step S1460, a pixel signal of a scanned row is transmitted to the memory 1305 and primarily stored. After that, the processing returns to step S1420, and a failure detection operation is continued. On the other hand, in a case where it is determined as a result of the equality determination in step S1440 that the expected output value and the actual output value are not equal, the processing proceeds to step S1470. In step S1470, it is determined that an image capturing operation is abnormal, and an alarm is raised to the main control unit 1313 or the alarm apparatus 1312. The alarm apparatus 1312 displays that an abnormality has been detected, on a display unit. After that, in step S1480, the photoelectric conversion apparatus 1302 is stopped, and an operation of the optical detection system 1301 is ended.

In the present exemplary embodiment, an example in which the processing of the flowchart is looped for each row has been exemplified, but the processing of the flowchart may be looped for every several rows, or a failure detection operation may be performed for each frame. The alarm raised in step S1470 may be conveyed to the outside of the vehicle via a wireless network.

In addition, in the present exemplary embodiment, the description has been given of the control performed in such a manner as not to collide with another vehicle, but the optical detection system 1301 can also be applied to the control for performing automatic operation by following another vehicle, or the control for performing automatic operation in such a manner as not to deviate from a lane. Furthermore, the optical detection system 1301 can be applied to a movable body (moving apparatus) such as a vessel, an aircraft, or an industrial robot, aside from a vehicle such as an automobile. Moreover, the optical detection system 1301 can be applied to a device that extensively uses object recognition, such as an intelligent transport system (ITS), in addition to a movable body.

The photoelectric conversion apparatus according to an exemplary embodiment of the present invention may be configured to further acquire various types of information such as distance information.

### <Eighth Exemplary Embodiment>

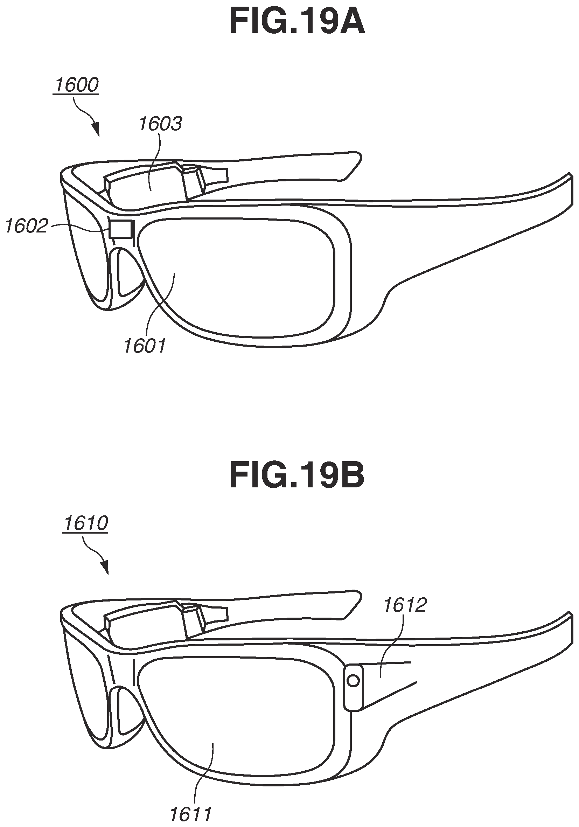

Fig. 19A illustrates eyeglasses 1600 (smart glass) according to an application example. The eyeglasses 1600 include a photoelectric conversion apparatus 1602. The photoelectric conversion apparatus 1602 is the photoelectric conversion apparatus described in any of the above-described exemplary embodiments. A display device including a light emission device such as an organic light emitting diode (OLED) or an LED may be provided on the back surface side of a lens 1601. The number of photoelectric conversion apparatuses 1602 may be one or plural. In addition, a plurality of types of photoelectric conversion apparatuses may be used in combination. An arrangement position of the photoelectric conversion apparatus 1602 is not limited to the position illustrated in Fig. 19A.

The eyeglasses 1600 further include a control apparatus 1603. The control apparatus 1603 functions as a power source that supplies power to the photoelectric conversion apparatus 1602 and the above-described display device. The control apparatus 1603 also controls operations of the photoelectric conversion apparatus 1602 and the display device. In the lens 1601, an optical system for condensing light to the photoelectric conversion apparatus 1602 is formed.

Fig. 19B illustrates eyeglasses 1610 (smart glass) according to an application example. The eyeglasses 1610 include a control apparatus 1612, and the control apparatus 1612 is equipped with a photoelectric conversion apparatus equivalent to the photoelectric conversion apparatus 1602, and a display device. In a lens 1611, an optical system for projecting light emitted from the photoelectric conversion apparatus and the display device in the control apparatus 1612 is formed, and an image is projected onto the lens 1611. The control apparatus 1612 functions as a power source that supplies power to the photoelectric conversion apparatus and the display device, and controls operations of the photoelectric conversion apparatus and the display device. The control apparatus may include a visual line detection unit that detects a visual line of a wearer. Infrared light may be used for the detection of a visual line. An infrared light emission unit emits infrared light onto an eyeball of a user looking at a displayed image. An imaging unit including a light receiving element detects reflected light of the emitted infrared light that has been reflected from the eyeball. A captured image of the eyeball is thereby obtained. By including a reduction unit for reducing light from the infrared light emission unit to a display unit in a planar view, a decline in image quality is suppressed.

From a captured image of an eyeball obtained by the image capturing using infrared light, a visual line of a user with respect to a displayed image is detected. An arbitrary known method can be applied to visual line detection that uses a captured image of an eyeball. As an example, a visual line detection method that is based on a Purkinje image obtained by reflection of irradiating light on a cornea can be used.

More specifically, visual line detection processing that is based on the pupil center corneal reflection is performed. By calculating an eye vector representing the direction (rotational angle) of an eyeball, based on an image of a pupil included in a captured image of the eyeball, and a Purkinje image, using the pupil center corneal reflection, a visual line of a user is detected.

The display device of the present exemplary embodiment may include the photoelectric conversion apparatus including a light receiving element, and a displayed image on the display device may be controlled based on visual line information of the user from the photoelectric conversion apparatus.

Specifically, in the display device, a first eyeshot region viewed by the user, and a second eyeshot region other than the first eyeshot region are determined based on the visual line information. The first eyeshot region and the second eyeshot region may be determined by a control apparatus of the display device, or the first eyeshot region and the second eyeshot region determined by an external control apparatus may be received. In a display region of the display device, a display resolution of the first eyeshot region may be controlled to be higher than a display resolution of the second eyeshot region. In other word, a resolution of the second eyeshot region may be made lower than a resolution of the first eyeshot region.

In addition, the display region includes a first display region and a second display region different from the first display region. Based on the visual line information, a region with high priority may be determined from the first display region and the second display region. The first display region and the second display region may be determined by a control apparatus of the display device, or the first display region and the second display region determined by an external control apparatus may be received. A resolution of a region with high priority may be controlled to be higher than a resolution of a region other than the region with high priority. In other words, a resolution of a region with relatively-low priority may be set to a low resolution.

Artificial intelligence (AI) may be used for determining the first eyeshot region and the region with high priority. The AI may be a model configured to estimate an angle of a visual line, and a distance to a target object existing at the end of the visual line, from an image of an eyeball using training data including an image of the eyeball, and a direction in which the eyeball in the image actually gives a gaze. An AI program may be included in the display device, may be included in the photoelectric conversion apparatus, or may be included in an external apparatus. In a case where an external apparatus includes an AI program, the AI program is transmitted to the display device via communication.

In a case where display control is performed based on visual detection, the present invention can be desirably applied to a smart glass further including a photoelectric conversion apparatus that captures an image of the outside. The smart glass can display external information obtained by image capturing, in real time.

### <Other Exemplary Embodiments>

Heretofore, the exemplary embodiments have been described, but the present invention is not limited to these exemplary embodiments, and various changes and modifications can be made. In addition, the exemplary embodiments can be applied to each other.

The present invention is not limited to the above embodiments and various changes and modifications can be made within the spirit and scope of the present invention. Therefore, to apprise the public of the scope of the present invention, the following claims are made.

This application claims priority from Japanese Patent Applications No. 2021-001441, filed January 7, 2021, and No. 2021-207158, filed December 21, 2021.

The following additional numbered clauses also define certain embodiments:

### [Clause 1]

A photoelectric conversion apparatus comprising:
an avalanche photodiode including an anode and a cathode;
a switch that is connected to one node of the anode and the cathode, and a power line to which a drive voltage is to be applied, and configured to switch a resistance value between the one node and the power line; and
a signal generation unit configured to generate a pulse signal for controlling switching of the switch,
wherein a value obtained by dividing the number of the pulse signals in a first exposure period by the first exposure period, and a value obtained by dividing the number of the pulse signals in a second exposure period having a length different from a length of the first exposure period, by the second exposure period are different.

### [Clause 2]

The photoelectric conversion apparatus according to Clause 1, wherein the pulse signal is a signal at a repeat cycle.

### [Clause 3]

The photoelectric conversion apparatus according to Clause 1 or 2, wherein the number of the pulse signals in the first exposure period and the number of the pulse signals in the second exposure period are same.

### [Clause 4]

The photoelectric conversion apparatus according to any one of Clauses 1 to 3,
wherein the first exposure period is shorter than the second exposure period, and
wherein a cycle of the pulse signal in the first exposure period is shorter than a cycle of the pulse signal in the second exposure period.

### [Clause 5]

The photoelectric conversion apparatus according to any one of Clauses 1 to 4, wherein a first pulse width at a first level of the pulse signal in the first exposure period and a first pulse width at a first level of the pulse signal in the second exposure period are same.

### [Clause 6]

The photoelectric conversion apparatus according to Clause 5, wherein a second pulse width at a second level of the pulse signal in the first exposure period and a second pulse width at a second level of the pulse signal in the second exposure period are different.

### [Clause 7]

The photoelectric conversion apparatus according to any one of Clauses 1 to 6, wherein the switch functions as a quench element.

### [Clause 8]

The photoelectric conversion apparatus according to any one of Clauses 1 to 7,
wherein the switch is a metal-oxide semiconductor (MOS) transistor,
wherein one node of the switch is connected to the cathode of the avalanche photodiode,
wherein another node of the switch is connected to the power line, and
wherein the pulse signal is supplied to a gate electrode of the switch.

### [Clause 9]

The photoelectric conversion apparatus according to any one of Clauses 1 to 8, further comprising a signal processing circuit including a waveform shaping unit and a counter circuit,
wherein the waveform shaping unit is connected to one node of the anode and the cathode, and
wherein a signal output from the waveform shaping unit is input to the counter circuit.

### [Clause 10]

The photoelectric conversion apparatus according to Clause 9, wherein the number of the pulse signals in the first exposure period is equal to an upper limit of the counter circuit.

### [Clause 11]

The photoelectric conversion apparatus according to Clause 9 or 10, further comprising a correction circuit,
wherein a count value output from the counter circuit is input to the correction circuit.

### [Clause 12]

The photoelectric conversion apparatus according to Clause 11, wherein, in the correction circuit, in a case where the count value, a frequency of the pulse signal in the first exposure period, and a length of the first exposure period are regarded as explanatory variables, and the number of incident photons is regarded as an objective variable, the explanatory variables and the objective variable are represented by a relational expression that is based on a natural logarithm.

### [Clause 13]

The photoelectric conversion apparatus according to Clause 11 or 12, wherein, in response to an input of the count value, the correction circuit outputs the number of incident photons Nph satisfying a relationship of: $Nct = f \times T \times \left(1-exp\left(-Nph/\left(f\times T\right)\right)\right) ,$ where the count value is denoted by Nct, the number of incident photons is denoted by Nph, a frequency of the pulse signal in the first exposure period is denoted by f, and the first exposure period is denoted by T.

### [Clause 14]

The photoelectric conversion apparatus according to Clause 11, wherein, in response to an input of the count value, the correction circuit outputs the number of incident photons Nph satisfying a relationship of: 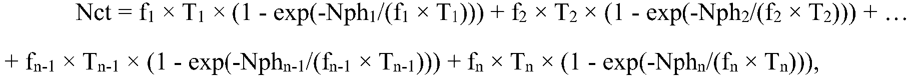 Nct = f1 × T1 × (1 - exp(-Nph1/(f1 × T1))) + f2 × T2 × (1 - exp(-Nph2/(f2 × T2))) + ... + fn-1 × Tn-1 × (1 - exp(-Nphn-1/(fn-1 × Tn-1))) + fn × Tn × (1 - exp(-Nphn/(fn × Tn))),
where the pulse signal includes n-types of frequencies,
a first frequency of the pulse signal is denoted by f₁, a second frequency is denoted by f₂, an (n-1)-th frequency is denoted by fₙ₋₁, and an n-th frequency is denoted by fₙ (n is a natural number equal to or larger than 2), and
a period during which a frequency of the pulse signal is the first frequency f₁ is denoted by T₁, a period during which a frequency of the pulse signal is the second frequency f₂ is denoted by T₂, a period during which a frequency of the pulse signal is the (n-1)-th frequency fₙ₋₁ is denoted by Tₙ₋₁, and a period during which a frequency of the pulse signal is the n-th frequency fₙ is denoted by Tₙ.

### [Clause 15]

The photoelectric conversion apparatus according to any one of Clauses 1 to 13, wherein, in a period other than the first exposure period and the second exposure period, the pulse signal is not input to the switch.

### [Clause 16]

The photoelectric conversion apparatus according to any one of Clauses 1 to 14, wherein a plurality of the avalanche photodiodes is arranged in a two-dimensional array in a planar view.

### [Clause 17]

A photoelectric conversion apparatus comprising:
an avalanche photodiode including an anode and a cathode;
a switch that is connected to one node of the anode and the cathode, and a power line to which a drive voltage is to be applied, and configured to switch a resistance value between the one node and the power line; and
a signal generation unit configured to generate a pulse signal for controlling switching of the switch,
wherein the signal generation unit includes a circuit configured to change a cycle of a pulse signal during an operation of a counter circuit.

### [Clause 18]

The photoelectric conversion apparatus according to Clause 17, wherein the circuit is a frequency divider circuit.

### [Clause 19]

The photoelectric conversion apparatus according to Clause 16 or 17,
wherein one node of the switch is connected with the cathode of the avalanche photodiode, and
wherein another node of the switch is connected to a power line to which a drive voltage is to be applied.

### [Clause 20]

The photoelectric conversion apparatus according to any one of Clauses 16 to 18,
wherein the switch is a metal-oxide semiconductor (MOS) transistor, and
wherein the pulse signal is supplied to a gate electrode of the switch.

### [Clause 21]

The photoelectric conversion apparatus according to any one of Clauses 16 to 19, further comprising a signal processing circuit including a waveform shaping unit and a counter circuit,
wherein the waveform shaping unit is connected to one node of the anode and the cathode, and
wherein a signal output from the waveform shaping unit is input to the counter circuit.

### [Clause 22]

An optical detection system comprising:
the photoelectric conversion apparatus according to any one of Clauses 1 to 20; and
a signal processing unit configured to process a signal output by the photoelectric conversion apparatus.

### [Clause 23]

An optical detection system comprising:
the photoelectric conversion apparatus according to any one of Clauses 1 to 12;
a signal processing unit configured to process a signal output by the photoelectric conversion apparatus; and
a shutter configured to control incidence of light to the photoelectric conversion apparatus,
wherein the first exposure period and the second exposure period are periods during which the shutter is opened.

### [Clause 24]

A movable body comprising:
the photoelectric conversion apparatus according to any one of Clauses 1 to 20; and
a distance information acquisition unit configured to acquire distance information indicating a distance to a target object, from distance measurement information that is based on a signal from the photoelectric conversion apparatus, the movable body further comprising:
   a control unit configured to control the movable body based on the distance information.

## Claims

1. A photoelectric conversion apparatus (100, 408, 1204, 1302, 1602) comprising:
a pixel including:
an avalanche photodiode (201) including an anode and a cathode;
a switch (202) connected between a power line to which a drive voltage (VH) is to be applied and either the anode or the cathode, and configured to receive pulse signals for controlling switching of the switch; and
a signal processing circuit including a counter circuit connected to the avalanche photodiode,
**characterized in that**:
a value obtained by dividing the number of the pulse signals in a first exposure period by the first exposure period, and a value obtained by dividing the number of the pulse signals in a second exposure period having a length different from a length of the first exposure period, by the second exposure period are different,
wherein each of the first exposure period and the second exposure period is a period from a timing at which an exposure control signal input to the pixel changes to a first level to a timing at which the exposure control signal changes to a second level.

2. The photoelectric conversion apparatus (100, 408, 1204, 1302, 1602) according to Claim 1, wherein the number of the pulse signals in the first exposure period and the number of the pulse signals in the second exposure period are the same.

3. The photoelectric conversion apparatus (100, 408, 1204, 1302, 1602) according to Claim 1 or 2,
wherein a cycle of the pulse signals in the first exposure period is shorter than a cycle of the pulse signals in the second exposure period.

4. The photoelectric conversion apparatus (100, 408, 1204, 1302, 1602) according to any one of Claims 1 to 3, wherein a first pulse width at a first level of the pulse signals in the first exposure period and a first pulse width at a first level of the pulse signals in the second exposure period are the same, and
wherein the first level of the pulse signals in the first exposure period is a level at which the switch (202) is turned on.

5. The photoelectric conversion apparatus (100, 408, 1204, 1302, 1602) according to Claim 4, wherein a second pulse width at a second level of the pulse signals in the first exposure period and a second pulse width at a second level of the pulse signals in the second exposure period are different, and
wherein the second level of the pulse signals in the first exposure period is a level at which the switch (202) is turned off.

6. The photoelectric conversion apparatus (100, 408, 1204, 1302, 1602) according to any one of Claims 1 to 5, wherein the switch (202) functions as a quench element.

7. The photoelectric conversion apparatus (100, 408, 1204, 1302, 1602) according to any one of Claims 1 to 6,
wherein the switch (202) is a metal-oxide semiconductor (MOS) transistor,
wherein one node of the switch (202) is connected to the cathode of the avalanche photodiode (201),
wherein another node of the switch (202) is connected to the power line, and wherein the pulse signals are supplied to a gate electrode of the switch (202).

8. The photoelectric conversion apparatus (100, 408, 1204, 1302, 1602) according to any one of Claims 1 to 7,
wherein the signal processing circuit (103) includes a waveform shaping unit (210),
wherein the waveform shaping unit (210) is connected to either the anode or the cathode, and
wherein a signal output from the waveform shaping unit (210) is input to the counter circuit (211).

9. The photoelectric conversion apparatus (100, 408, 1204, 1302, 1602) according to any one of Claims 1 to 8,
wherein the number of the pulse signals in the first exposure period is equal to an upper limit of the counter circuit (211).

10. The photoelectric conversion apparatus (100, 408, 1204, 1302, 1602) according to any one of Claims 1 to 9, further comprising a correction circuit (118),
wherein a count value output from the counter circuit (211) is input to the correction circuit (118), and
wherein, in response to an input of the count value, the correction circuit (118) converts the count value into a corrected value that corresponds to a number of actual incident photons.

11. The photoelectric conversion apparatus (100, 408, 1204, 1302, 1602) according to Claim 10, wherein, in the correction circuit (118), in a case where the count value, a frequency of the pulse signals in the first exposure period, and a length of the first exposure period are regarded as explanatory variables, and the number of incident photons is regarded as an objective variable, the explanatory variables and the objective variable are represented by a relational expression that is based on a natural logarithm.

12. The photoelectric conversion apparatus (100, 408, 1204, 1302, 1602) according to Claim 10 or 11, wherein, in response to an input of the count value, the correction circuit (118) outputs the number of incident photons Nph satisfying a relationship of: $Nct = f \times T \times \left(1-exp\left(-Nph/\left(f\times T\right)\right)\right) ,$ where the count value is denoted by Nct, the number of incident photons is denoted by Nph, a frequency of the pulse signals in the first exposure period is denoted by f, and the first exposure period is denoted by T.

13. The photoelectric conversion apparatus (100, 408, 1204, 1302, 1602) according to Claim 10, wherein, in response to an input of the count value, the correction circuit (118) outputs the number of incident photons Nph satisfying a relationship of: 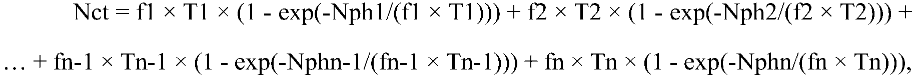 Nct = f1 × T1 × (1 - exp(-Nph1/(f1 × T1))) + f2 × T2 × (1 - exp(-Nph2/(f2 × T2))) + ... + fn-1 × Tn-1 × (1 - exp(-Nphn-1/(fn-1 × Tn-1))) + fn × Tn × (1 - exp(-Nphn/(fn × Tn))),
where the pulse signals includes n-types of frequencies,
a first frequency of the pulse signals is denoted by f1, a second frequency is denoted by f2, an (n-1)-th frequency is denoted by fn-1, and an n-th frequency is denoted by fn (n is a natural number equal to or larger than 2), and
a period during which a frequency of the pulse signals is the first frequency f1 is denoted by T1, a period during which a frequency of the pulse signals is the second frequency f2 is denoted by T2, a period during which a frequency of the pulse signals is the (n-1)-th frequency fn-1 is denoted by Tn-1, and a period during which a frequency of the pulse signals is the n-th frequency fn is denoted by Tn.

14. The photoelectric conversion apparatus (100, 408, 1204, 1302, 1602) according to any one of Claims 1 to 13, wherein, in a period other than the first exposure period and the second exposure period, the pulse signals are not input to the switch (202).

15. The photoelectric conversion apparatus (100, 408, 1204, 1302, 1602) according to any one of Claims 1 to 14, wherein a plurality of the avalanche photodiodes (201) is arranged in a two-dimensional array in a planar view.

16. An optical detection system (1100, 1200, 1301) **characterised in that** it comprises: the photoelectric conversion apparatus (1204, 1302) according to any one of Claims 1 to 15; and
a signal processing unit (1205) configured to process a signal output by the photoelectric conversion apparatus.

17. The optical detection system (1200) according to Claim 16, further comprising:
a shutter (1222) configured to control incidence of light to the photoelectric conversion apparatus,
wherein the first exposure period and the second exposure period are periods during which the shutter (1222) is opened.

18. A movable body (1300) comprising:
the photoelectric conversion apparatus (100, 408, 1204, 1302, 1602) according to any one of Claims 1 to 15; and
a distance information acquisition unit (401, 1205) configured to acquire distance information indicating a distance to a target object, from distance measurement information that is based on a signal from the photoelectric conversion apparatus, the movable body further comprising:
a control unit configured to control the movable body based on the distance information.
